(19) Europäisches Patentamt / European Patent Office / Office européen des brevets

(11) EP 2 966 145 A1

(12) EUROPEAN PATENT APPLICATION

(43) Date of publication:
**13.01.2016 Bulletin 2016/02**

(51) Int Cl.:
***C09K 11/06** (2006.01)* ***H05B 33/10** (2006.01)*

(21) Application number: **14176715.2**

(22) Date of filing: **11.07.2014**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **Dyenamo AB**
**187 34 Täby (SE)**

(72) Inventors:
- **Xu, Bo**
  **170 70 Solna (SE)**
- **Sheibani, Esmaeil**
  **115 57 Stockholm (SE)**
- **Sun, Licheng**
  **186 50 Vallentuna (SE)**

(74) Representative: **Awapatent AB**
**P.O. Box 45086**
**104 30 Stockholm (SE)**

(54) **Carbazole based hole transport materials**

(57) The present invention relates to hole transport and hole conducting materials that may be of use in solar cell devices. These materials have the general structure $B_1$-$A_1$-$B_2$ wherein $B_1$ represents a structure of formula I.

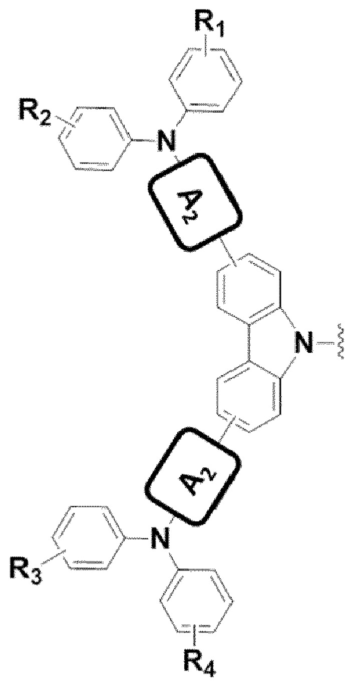

(I)

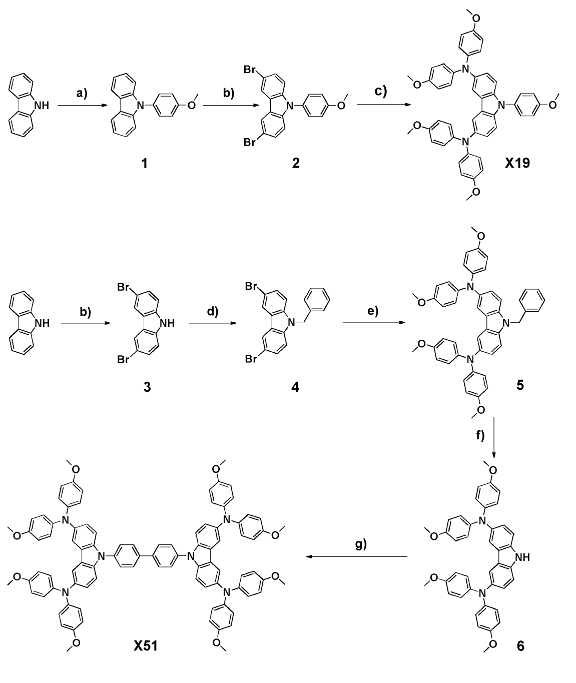


Figure 1

EP 2 966 145 A1

## Description

### Technical field

The present invention relates to the field of solar cells, and to hole transport materials (HTMs) that may be used in such solar cells.

### Background

With the recent rise in awareness of environmental and energy issues, renewable energy sources are being given more and more attention. Looking at photovoltaics, dye-sensitized solar cells (DSCs) are considered to be a promising candidate for a large-area and low-cost renewable-energy source.

In this rapidly developing field, finding efficient electrolytes to improve efficiency is of great importance for the promotion of DSCs. So far, the best conversion efficiency of 13% have been obtained with prophyrin-based dyes used together with the Co(II/III)tris(bipyridyl)complexes-based redox couple (A. Vella et al, Science 2011, 334, 629; S. Mathew et al, Nat Chem 2014, 6, 242).

Despite the fact that considerable progress has been made in this field of research, the potential of leakage problem associated with the volatile nature of the liquid electrolyte, together with stability issue and are the limitations for commercialization of these devices. A significant part of the efforts made in this field has been the optimization of the fabrication of solar cells based on solid-state hole transport materials (HTMs) instead of redox couplers. To date, the highest efficiencies with 7.2 % for solid-state dye-sensitized solar cells (ssDSCs) (J. Burschka et al, JACS 2011, 133, 18042) and 15.4% for perovskite solar cells (PSCs) (H.-S. Kim et al, Nature 2013, 499, 316.) have been achieved using SpiroOMeTAD as the HTM. However, the previous studies have demonstrated that the onerous synthesis and low charge carrier mobility of Spiro-OMeTAD significantly limits its scale-up applications in ssDSCs and PSCs. Therefore, the development of new generation HTMs with low-cost and high charge carrier mobility is highly desired.

Carbazole-based derivatives attracted much attention for their interesting photochemical properties as well as high chemical and environmental stability (A. W. Schmidt et al, Journal of Power Sources 2013, 233, 86). One of the recent focuses is its good charge transport function that can be used in the molecular design of new type of HTMs in organic light-emitting diode (OLED) and electron donor of organic D-$\pi$-A sensitizer in DSCs. There is thus a need in the art for development of new HTMs with improved properties, such as new carbazole based HTMs, for use in electronic devices such as solar cells.

### Summary of the invention

It is an object of the present invention to provide novel hole conducting materials useful in solar cell devices.

It is a further object of the present invention to provide novel hole conducting- and/or hole transport materials which may be produced at a lower cost than presently available hole conducting- and hole transport materials and which preferably display improved characteristics and performance when used in electronic applications and devices such as solar cells.

It is a further object of the present invention to provide novel solar cells comprising such novel hole conducting- and/or hole transport materials, which demonstrate improved performance when compared to prior art solar cells.

These objects are achieved, according to a first aspect of the invention, by the provision of a hole-conducting material comprising a compound of the general formula:

$$B_1\text{-}A_1\text{-}B_2$$

wherein $B_1$ represents a structure of formula I

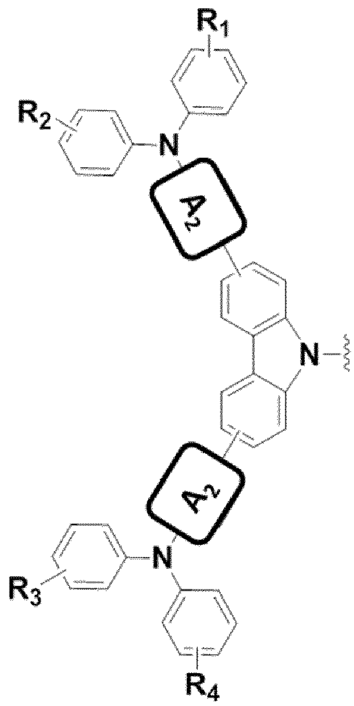

(I),

wherein $A_2$ represents a structure independently selected from the group consisting of

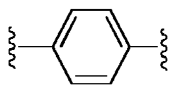
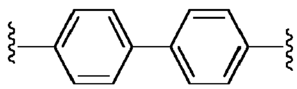
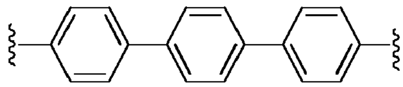
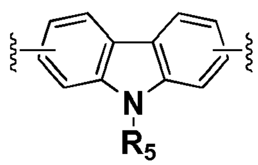
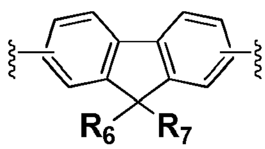
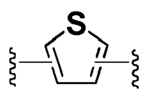
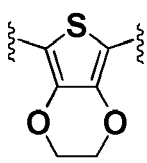
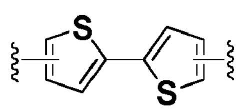

and

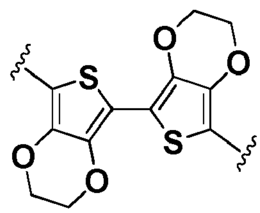

or wherein $A_2$ is independently absent

$A_1$ represents a structure independently selected from the group consisting of

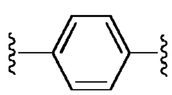
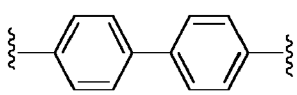
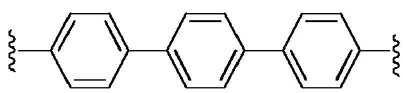
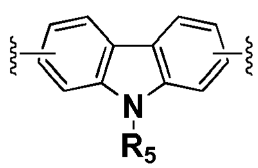
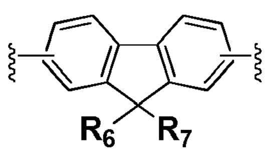
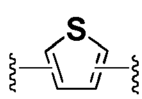

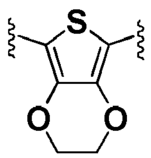

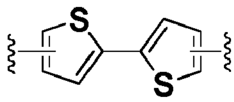

and

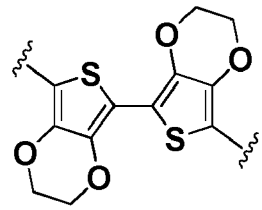

and $B_2$ represents a structure of formula I, or

$A_1$ is

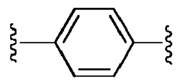

and $B_2$ is $R_8$, and each of $R_1$, $R_2$, $R_3$, $R_4$, $R_5$, $R_6$, $R_7$, and $R_8$ independently represents alkoxy, aryloxy, alkyl, aryl or hydrogen.

The new hole conducting or hole transport material (HTMs) displays improved characteristics as such, in terms of e.g. hole transport mobility, and in particular when utilized in electronic devices such as solar cells, in terms of e.g. photovoltaic parameters such as current density and voltage. It is expected that the electrochemical properties of the HTMs according to the invention will lead to a better performance in a solar cell device as compared to prior art HTMs. To achieve high performance, high hole mobility and conductivity or the HTM may prove particularly important. The inventors have demonstrated the particular benefits of example HTMs according to the invention, as presented in the appended Examples.

In the context of the present invention, the terms "hole transport material", "hole transport agent" "hole conductor", and hole conducting agent" are used interchangeably.

Each of the following individual embodiments accounted for below relate, unless specified otherwise, to all aspects of the present invention.

In an embodiment, $A_2$ is absent.

In an embodiment, each of $R_1$, $R_2$, $R_3$, $R_4$, $R_5$, $R_6$, $R_7$, and $R_8$ independently represents methoxy, aryl, alkyl, or hydrogen.

In an embodiment, at least one of $R_1$, $R_2$, $R_3$, and $R_4$ is methoxy, preferably at least two of $R_1$, $R_2$, $R_3$, and $R_4$ are methoxy, more preferably at least three of $R_1$, $R_2$, $R_3$, and $R_4$ are methoxy, and most preferably each of $R_1$, $R_2$, $R_3$, and $R_4$ is methoxy. In an embodiment, $R_8$ is methoxy.

In an embodiment, $R_5$ is H.

In an embodiment, $R_6$ is H.

In an embodiment, $R_6$ is H.

In an embodiment, $R_7$ is H.

In an embodiment, at least one of $R_1$, $R_2$, $R_3$, and $R_4$ is a substituent on the fourth carbon atom of the phenyl group; such as at least two, three or all of $R_1$, $R_2$, $R_3$, and $R_4$ are substituents on the fourth carbon atom of a phenyl group.

In an embodiment, $B_2$ is $R_8$.

In an embodiment, $-A_1-B_2$ is represented by the structure

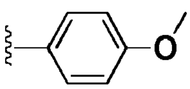.

imen

In an embodiment, said compound of general formula $B_1-A_1-B_2$ is a compound of formula II:

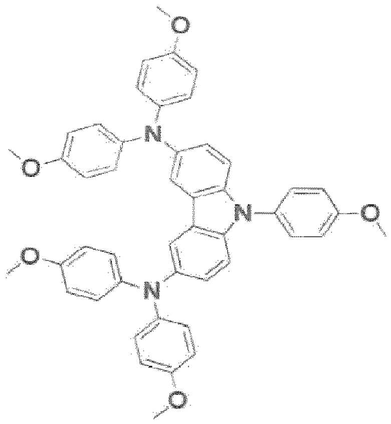

(II).

In an embodiment, $A_1$ is

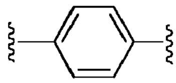

.

In an embodiment, $A_1$ is

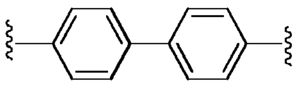

.

In an embodiment, $B_2$ represents a compound of formula I. In an embodiment the structures of $B_1$ and $B_2$ are identical.

In an embodiment, wherein said compound of general formula $B_1$-$A_1$-$B_2$ is a compound of formula III:

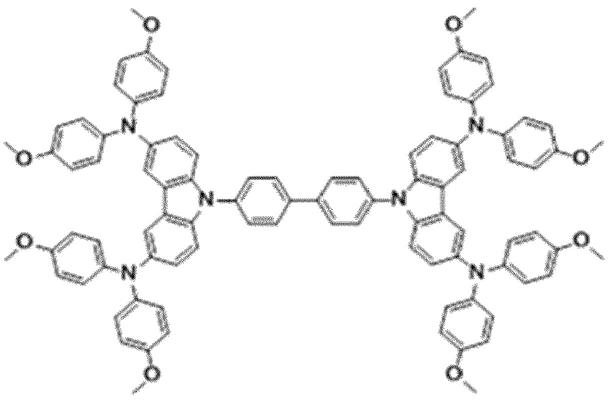

(III).

The new HTMs as defined in formula (II) and (III) have different molecular weight, oxidation potential, hole mobility and conductivity. These compounds according to formula (II) and (III), also denoted X19 and X51 herein, have small reorganization energies which imply fast hole transport properties. The X51 compound proved to have the best properties with regards to reorganization energy and hole transport properties. By optimizing aforementioned parameters of the above HTMs in conjunction with ssDSC operation and employing a photosensitizer (e.g. LEG4), devices with the HTMs exhibited high power conversion efficiencies (PCEs) which were comparable with and, in some cases, surpassed the PCEs obtained by using the state-of-the-art HTM Spiro-OMeTAD. Also, while employing perovskite as photosensitizer, devices with the HTMs according to the invention exhibited as high PCEs as can be obtained by using Spiro-OMeTAD, or even higher PCEs. These findings thus indicate that the HTMs according to the invention may be used for preparing high efficiency solar cells such as ssDSCs and PSCs.

In an embodiment the hole-conducting material is doped. The hole-conducting material may for example be doped using Li-TFSI or H-TFSI. In an embodiment the hole-conducting material is $Li^+$ doped. In an embodiment the hole-conducting material is doped using Li-TFSI.

In an embodiment, said compound of general formula $B_1$-$A_1$-$B_2$ is in solid state.

According to a second aspect of the invention, there is provided a solar cell device comprising a hole-conducting material according to the first aspect described herein.

In an embodiment, said device is selected from a dye-sensitized solar cell and a hybrid solar cell. In a particular embodiment, said device is a solid state dye-sensitized solar cell.

In an embodiment, the solar cell device comprises a plurality of layers, wherein said compound of general formula $B_1$-$A_1$-$B_2$ is comprised within a hole-conducting layer of said plurality of layers.

There is, in a further aspect, provided a process for preparing a hole-conducting material, said process comprising the steps of:

a) providing carbazole;
b) subjecting said carbazole of step a) to arylation;
c) subjecting said carbazole of step b) to a Pd catalyzed aryl amination, and optionally,
d) repeating steps a)-c), and
e) reacting the compound of step c) with the compound of step d).

In a related embodiment, the hole conducting material of the invention is prepared by a process as described above.

**Brief description of the drawings**

These and other aspects of the present invention will now be described in more detail, with reference to the appended drawings, wherein:

Figure 1 depicts the synthesis routes of the carbazol based HTM compounds denoted X19 and X51. Conditions: a) p-iodoanisole,CuI, 1,10-phenanthroline, $K_2CO_3$, DMF, Reflux, 24 h, (yield 92 %); b) NBS, DMF, RT, Overnight, (yield 85 %); c) 4,4'-Dimethoxydiphenylamine, $Pd_2(bda)_3$, $(t\text{-}Bu)_3P$,t-BuONa, Toluene, Reflux, Overnight, (yield 88 %); d) Benzyl bromide, NaH, DMF, RT, 7 h, quantitative yield; e) 4,4'-Dimethoxydiphenylamine, $Pd_2(bda)_3$, $(t\text{-}Bu)_3P$,t-BuONa, Toluene, Reflux, 24 h, (yield 76 %); f) t-BuOK, DMSO, RT, Overnight (yield 83 %); g) 4,4'-Diiodobiphenyl, CuI, 1,10-phenanthroline, $K_2CO_3$, DMF, Reflux, 24 h, (yield 60 %);
Figure 2a is $^1$H NMR ($d_6$-DMSO) spectra of a carbazol based compound according to the invention denoted X19;
Figure 2b is $^{13}$C NMR ($d_6$-DMSO) spectra of the carbazol based compound X19;
Figure 3a is $^1$H NMR ($d_6$-DMSO) spectra of a carbazol based compound according to the invention denoted X51;
Figure 3b is $^{13}$C NMR ($C_6D_6$) spectra of the carbazol based compound X51;
Figure 4a is a HR-MS spectra of the carbazol based compound X19;
Figure 4b is a HR-MS spectra of the carbazol based compound X51;
Figure 5 shows cyclic voltammograms of the carbazole based compounds X19 (a), X51 (b), as well as Spiro-OMeTAD (c) and Ferrocene (d), all tested in DCM ($10^{-4}$M);
Figure 6 shows J-V curves with different concentrations of Li-TSFI for ssDSCs devices based on the carbazol based compounds X19 (a), X51 (b), as well as Spiro-OMeTAD (c) as HTMs, and for perovskite-sensitized devices based on Spiro-OMeTAD (d) as HTM, and
Figure 7 show the frontier orbitals of two HTMs according to the invention and of Spiro-OMe-TAD.
Figure 8a shows normalized UV-Visible absorption and photoluminescence spectra for X19, X51 and Spiro-OMeTAD.
Figure 8b shows normalized differential pulsed voltammetry (DPV) curves for X19, X51 and Spiro-OMeTAD.
Figure 9a shows IPCE spectra for LEG4 dye with X19, X51 and Spiro-OMeTAD.
Figure 9b shows IPCE spectra for perovskite with X19, X51 and Spiro-OMeTAD.

**Examples**

Example 1: Preparation of carbazol-based hole transport materials

*General materials and methods*

Bis(trifluoromethane)sulfonimide lithium salt (Li-TSFI, 99.95 %) and 4-tert-butylpyridine (t-BP,96 %) were purchased from Aldrich. The t-BP was distilled before using. Chlorobenzene (anhydrous 99.8 %) and acetonitrile (anhydrous 99.8 %) was used as received. Dye LEG4 was provided by Dyenamo AB. Solvents and other chemicals are also commercial available and used as received unless specially stated. Chromatography was performed using silica gel 60 A (35-63 μm). NMR spectra were recorded on a Bruker AVANCE 500 MHz spectrometer.

*Synthesis of 9-(4-methoxyphenyl)-9H-carbazole (1)*

As a general procedure for the N-arylation reaction of carbazole, p-iodoanisole (9.24 g, 39.48 mmol), carbazole (6.0 g, 35.88 mmol), copper (I) iodide (1.02 g, 5.38 mmol), 1,10-phenanthroline (0.097 g, 5.38 mmol), $K_2CO_3$ (4.96 g, 35.88 mmol), were added to dried DMF (100 mL) and the reaction mixture was refluxed under argon atmosphere for 24 h. DMF was evaporated under vacuum and the residue was extracted with dichloromethane, dried with ($Na_2SO_4$) and evaporated the solvent. The crude was purified by chromatography petroleum ether/ethyl acetate (10: 1) to afford 9.02 g (92 %) of product as a white powder.

Compound 1 was characterized by $^1$H NMR (500 MHz, CDCl3,298 K),δ(ppm): 8.16 (d, J = 7.8 Hz, 2H), 7.48 (d, J = 8.8 Hz, 2H), 7.42 (t, J = 7.7 Hz, 2H), 7.35 (d, J = 7.7 Hz, 2H), 7.27 (t, J = 7.7 Hz, 2H), 7.11 (d, J = 8.7 Hz, 2H), 3.92 (s,3H, OMe).

*Synthesis of 3,6-dibromo-9-(4-methoxyphenyl)-9H-carbazole (2):*

Compound 1 (see Fig. 1, 4 g, 14.64 mmol) was dissolved in dried DMF (40 mL) and cooled in an ice bath. A solution of N-bromosuccinimide (5.73 g, 32.2 mmol) in dried DMF (15 mL) was added slowly to the reaction mixture then removed the ice bath and it was stirred at RT overnight. DMF was evaporated under vacuum and solid was further crystallized from EtOH to afford 5.36 g (85 %) of compound 2 (see Fig. 1) as a white solid.

Compound 2 was characterized by $^1$H NMR (500 MHz, $CDCl_3$,298 K), δ(ppm):8.19 (d, *J* = 1.8 Hz, 2H), 7.49 (dd, J = 1.8 Hz, *J* = 8.7 Hz, 2H), 7.38 (d, *J*= 8.7 Hz, 2H), 7.17 (dd, J = 1.8 Hz, *J* = 8.7 Hz, 2H), 7.11 (d, *J* = 8.8 Hz, 2H), 3.92 (s, 3H, OMe).

*Synthesis of N3,N3,N6,N6,9-pentakis(4-methoxyphenyl)-9H-carbazole-3,6-diamine (X19):*

The synthesis of compound X19 (See Fig. 1) was obtained by Buchwald-Hartwig reaction in which 4,4'-Dimethoxydiphenylamine (2 g, 8.73 mmol), compound 2 (1.5 g, 3. 49 mmol), NaOtBu (0.83 g, 8.73 mmol), was added to 50 ml of dry toluene. The system was purged with nitrogen several times. Then $(t\text{-}Bu)_3P$ (0.09 g, 12%mol), $Pd_2(bda)_3$ (0.21 g, 6 % mol) was placed in mixture solution and reaction was refluxed overnight. Organic phase separation by ethyl acetate and combined organic phases were dried with $MgSO_4$ and purified with chromatography petroleum ether/ethyl acetate (2:1) to afford 2.23 g (88 % yield) of X19.

Compound X19 was characterized by $^1$H NMR (500 MHz, $d_6$-DMSO, 298 K), δ (ppm): 7.58 (s, 2H), 7.36 (d, *J* = 8.6 Hz, 2H), 7.12 (d, *J* = 8.7 Hz, 4H), 7.02 (d, *J* = 8.7 Hz, 2H), 6.77 (m, 8H), 6.74 (m, 8H), 3.85 (s, 6H, OMe), 3.65 (s, 3H, OMe). $^{13}$C NMR (500 MHz, $d_6$-DMSO, 298 K), δ (ppm): 158.25, 154.01, 141.77, 140.76, 137.48, 129.18, 128.01, 124.23, 123.65, 122.82, 116.36, 115.06, 114.42, 110.33, 55.22, 54.93.HR-MS (ESI) m/z: $[M]^+$ calcd for 727.3046; found, 727.2982.

*Synthesis of 3, 6-dibromo-9H-carbazole (3):*

Bromination of carbazole was done according to the same procedure as compound 2.

The yield of resulting compound 3 (see Fig. 1) was 89 %. The product was further characterized by $^1$H NMR (500 MHz, $CDCl_3$, 298 K), δ (ppm): 8.14 (s, 2H), 8.11 (s, 1 H, NH), 7.52 (d, *J* = 8.3 Hz, 2H), 7.32 (d, *J* = 8.3 Hz, 2H).

*Synthesis of 9-benzyl-3, 6-dibromo-9H-carbazole (4):*

NaH (0.55 g, 23.08 mmol) was added in one portion to dried DMF (50 mL), a solution of compound 3 (5.00 g, 15.38 mmol) in DMF (20 mL) was added dropwise. After one hour, benzyl bromide (1.83 mL, 15.38 mmol) was added slowly. The suspension was stirred for another 6 h under nitrogen and carefully quenched with water. Then the precipitate was filtrated to give white precipitate with quantitative yield, 6.38 g (compound 4, Fig. 1).

The product was characterized by $^1$H NMR (500 MHz, $CDCl_3$, 298 K), δ (ppm):8.20 (d, *J* = 1.9 Hz, 2H), 7.53 (dd, J = 1.9 Hz, *J* = 8.1 Hz, 2H), 7.25 (m, 5H), 7.07 (d, *J* = 8.1 Hz, 2H), 5.48 (s, 2H, $CH_2$).

*Synthesis of 9-benzyl-N3,N3,N6,N6-tetrakis(4-methoxyphenyl)-9H-carbazole-3, 6- diamine (5):*

Buchwald-Hartwig reaction between compound 4 (Fig. 1, 5.0 g, 12.04 mmol), 4,4'-Dimethoxydiphenylamine (6.07 g, 26.5 mmol) and NaOtBu (2.88 g, 30.01 mmol) were put in the round bottom flask equipped with stirring bar in dry toluene (60 ml). Then $(t\text{-}Bu)_3P$ (0.38 g, 15 % mol), $Pd_2(bda)_3$ (0.74 g, 4 % mol) was added under nitrogen. The mixture was refluxed and the reaction was followed by TLC. Reaction was stopped after 24 hours. The aqueous phase was extracted with $CH_2Cl_2$ (3 × 50 ml). The combined organic phases were dried with $MgSO_4$ and purified with chromatography (PE:EtOAc 5:1) to afford 6.5 g (76 % yield) of compound 5 (Fig. 1).

Compound 5 was further characterized by $^1H$ NMR (500 MHz, $d_6$-DMSO, 298 K), δ (ppm): 7.63 (s, 2H), 7.41 (d, *J* = 8.3 Hz, 2H), 7.25 (m, 5H), 7.11 (d, *J* = 8.3 Hz, 2H), 6.89 (d, *J* = 8.8 Hz, 8H), 6.77 (d, *J* = 8.8 Hz, 8H), 5.56 (s, 2H, $CH_2$),3.72 (s, 12H, OMe). In addition, characterization by $^{13}C$ NMR (500 MHz, $d_6$-DMSO, 298 K), δ (ppm) was performed: 155.75, 143.40, 142.02, 138.84, 138.47, 129.26, 128.15, 127.63, 125.43, 125.20, 124.94, 124.25, 117.16, 115.52, 115.27, 114.99, 110.87, 60.48, 55.59.

*Synthesis of N3,N3,N6,N6-tetrakis(4-methoxyphenyl)-9H-carbazole-3,6-diamine (6):*

To a stirred of compound 5 (2.90 g, 4.07 mmol) in 120 mL DMSO was added KOtBu (40.74 mmol, 1 M solution of KOtBu in THF) at room temperature. The reaction mixture was stirred for 20 min and $O_2$ was bubbled for the reaction with 3 h. 200 ml of water was poured to reaction solution and stirred overnight. The precipitate was filtrated and purified by column chromatography with petroleum ether/ethyl acetate (4:1) to give a light yellow solid compound 6 (2.1 g).

The yield of compound 5 was 83 %. The compound was characterized by $^1H$ NMR and $^{13}C$ NMR. $^1H$ NMR (500 MHz, $d_6$-DMSO, 298 K), δ (ppm):7.64 (s, 2H), 7.44 (d, *J* = 8.6 Hz, 2H), 7.13 (dd, *J* = 2.1 Hz, *J* = 8.6 Hz, 2H), 6.94 (d, *J* = 8.7 Hz, 8H), 6.8 (d, *J* = 8.7 Hz, 8H), 3.74 (s, 12H, OMe). $^{13}C$ NMR (500 MHz, $d_6$-DMSO, 298 K), δ (ppm): 155.74, 143.60, 141.73, 138.17, 129.53, 127.70, 125.28, 125.10, 124.68, 124.64, 117.20, 115.31, 112.60, 112.55, 55.66.

*Synthesis of 9,9'-([1,1'-biphenyl]-4,4'-diyl)bis(N3,N3,N6,N6-tetrakis(4-methoxy-phenyl)-9H-carbazole-3,6-diamine) (X51):*

The reaction condition was conducted essentially according to the procedure for the N-arylation reaction of carbazole. Compound 6 (Fig. 1, 1 g, 1.06 mmol), 4,4'-Iodobiphenyl (0.26 g, 0.64 mmol), copper (I) iodide (0.06 g, 0.21 mmol), 1,10-phenanthroline (0.06 g, 0.21 mmol), $K_2CO_3$ (0.29 g, 2.12 mmol) were added to dried DMF (30 mL) and the reaction mixture was refluxed under argon for 24 h. DMF was evaporated under vacuum and phase extraction was done with ethyl acetate, dried with $MgSO_4$ and evaporated the organic solvent. The crude was purified by chromatography petroleum ether/ethyl acetate (2: 1) to afford 0.57 g of X51 with yield 60 %.

X51 was characterized by $^1H$ NMR (500 MHz, $d_6$-DMSO, 298 K), δ (ppm):7.98 (d, *J* = 8.4 Hz, 4H), 7.65 (m, 8H), 7.26 (d, *J* = 8.4 Hz, 4H), 7.04 (d, *J* = 8.4 Hz, 4H), 6.84 (m, 16H), 6.84 (m, 16H), 6.77 (m, 16H), 3.66 (s, 24H, OMe). The corresponding $^{13}C$ NMR (500 MHz, $C_6D_6$, 298 K), δ (ppm):155.44, 143.13, 142.64, 139.19, 138.26, 137.79, 128.71, 128.34, 128.14, 127.95, 127.40, 125.49, 125.08, 124.78, 117.73, 115.08, 111.16, 55.07. HR-MS (ESI) m/z: $[M]^+$ calcd for 1392.5725; found, 1393.5820.

<u>Example 2: Device Fabrication and measurements</u>

*Optical Characterization*

UV-Vis absorption spectra were recorded on a Lambda 750 UV-Vis spectrophotometer. The fluorescence spectra of dye solutions were recorded on a Cary Eclipse fluorescence spectrophotometer. All samples were measured in a 1 cm cell at room temperature at a concentration of $10^{-5}$ M in dichloromethane.

*Electrochemical Measurements*

Electrochemical experiments were performed with a CH Instruments electrochemical workstation (model 660A) using a conventional three-electrode electrochemical cell. A dichloromethane solution (DCM) containing 0.1 M of tetrabutylammoniunhexafluorophosphate ($n\text{-}Bu_4NPF_6$) was introduced as electrolyte, where an Ag/0.01 M $AgNO_3$ electrode (acetonitrile as solvent) was used as the reference electrode and a glassy carbon disk (diameter 3mm) as the working electrode, a platinum wire as the counter electrode. The cyclovoltammetric scan rates were 50 mV/s. All redox potentials were calibrated vs. normal hydrogen electrode (NHE) by the addition of ferrocene. The conversion $E_{(Fc/Fc+)}$ = 630 mV vs NHE. Resulting cyclic voltagrams are shown in Fig. 5.

*Mobility Measurements*

Charge transport in the carbazol based HTMs according to the invention (i.e X19, X51) has been investigated according to literature (T. Leijtens et al, ACS Nano 2012, 6, 1455). Fluorine-doped tin-oxide (FTO) coated glass substrates (Pilkington TEC15) were patterned by etching with zinc powder and 2 M hydrochloric acid. The substrates were carefully cleaned in ultrasonic baths of detergents, deionized water, acetone and ethanol successively. The remaining organic residues were removed with 10 min by airbrush.A 40 nm thick PEDOT: PSS layer was spin-coated onto the substrates, which were then annealed at 120 °C for 30 min in air. The substrates were then transferred into a glovebox for further fabrication steps. The HTMs were dissolved in anhydrous chlorobenzene with 10 mg/ml at 70 °C. This solution was spin-coated at 2000 rpm to yield films. The thicknesses of the films are measured by using a Dektak 6M profilometer. 200 nm of silver was then evaporated onto the active layer under high vacuum (less than $10^{-6}$ mbar). J-V characteristics of the devices have been measured with a Keithley 2400 Source-Measure unit, interfaced with a computer. Device characterization was carried out in air.

*Conductivity Measurements*

Glass substrates without conductive layer were carefully cleaned in ultrasonic baths of detergents, deionized water, acetone and ethanol successively. Remaining organic residues were removed with 10 min by airbrushing. A thin layer of nanoporous $TiO_2$ was coated on the glass substrates by spin-coating with a diluted $TiO_2$ paste (Dyesol DSL 18NR-T) with terpineol (1:3, mass ratio). The thickness of the film is ca. 500 nm, as measured with a DekTak profilometer. After sintering the $TiO_2$ film on a hotplate at 500 °C for 30 min, the film was cooled to room temperature, before it was subsequently deposited by spin-coating of a solution of carbazol based HTM in chlorobenzene, whereas the concentrations were the same as in case of photovoltaic devices. J-V characteristics were recorded on a Keithley 2400 Semiconductor Characterization System.

*Device Fabrication- ssDSCs*

Fluorine-doped tin-oxide (FTO) coated glass substrates (Pilkington TEC15) were patterned by etching with zinc powder and 2 M hydrochloric acid. The substrates were carefully cleaned in ultrasonic baths of detergents, deionized water, acetone and ethanol successively. The remaining organic residues were removed with 10 min by airbrush. A compact $TiO_2$ blocking layer was deposited onto the surface of a pre-cleaned FTO substrate by spray pyrolysis on a hotplate at 450 °C using an airbrush. The solution used in the spray pyrolysis was 0.2 M Ti-isopropoxide, 2 M acetylacetone in isopropanol. In all electrode preparations 10 spray cycles were used as standard parameter. Nanoporous $TiO_2$ films were coated on the compact $TiO_2$ layer by screenprinting of a diluted $TiO_2$ paste (Dyesol DSL 18NR-T) with terpineol (2:1, mass ratio). The thickness of the film is ca. 2.0 $\mu$m, as measured with a DekTak profilometer. After sintering the $TiO_2$ film on a hotplate at 500 °C for 30 min, the film was cooled to room temperature and immersed in 0.02 M aqueous $TiCl_4$ at 70 °C for 30 min. The film was then rinsed by deionized water and then annealed on a hotplate at 500 °C for 30 min. After cooling to 90 °C, the film was immersed for 2 h in 0.1 mM solution of LEG4 dissolved in tert-butanol and acetonitrile (1:1), and then the sensitized electrodes were rinsed by ethanol and dried. Subsequently, the chlorobenzene solution containing the corresponding HTM and additives was applied to form the HTM film by leaving the solution to penetrate into the sensitized electrode for 30 s and then followed by spin-coating for 30 s with 2000 rpm. Afterwards, the cells were left in air overnight in the dark (humidity below 20%), then a 200 nm thick Ag back contact was deposited onto the organic semiconductor by thermal evaporation in a vacuum chamber with a base pressure of about $10^{-6}$ bar, to complete the device fabrication.

*Device Fabrication- Perovskite solar cells:*

The devices of perovskite solar cells were fabricated according to a published method (M. M. Lee et al, Science 2012, 338, 643). The washing and etching procedures were the same as in case of ssDSC devices. 4 spray cycles were used to prepare a thinner compact layer which is different with ssDSCs. A 350 nm thick layer of $TiO_2$ was deposited via spincoating at 3000 rpm for 30 s. The $TiO_2$ dispersion solution was used commercial $TiO_2$ paste (Dyesol 18-NRT) diluted in ethanol (2:7, weight ratio). After drying at 125°C, the $TiO_2$ film was sintered on a hotplate at 500 °C for 30 min. When the film was cooled to room temperature, the $CH_3NH_3PbI_{3-X}Cl_X$ perovskite precursor solution (3M methylammoniumiodide to 1 M lead chloride) was prepared to a concentration of 40 wt% in dry N-dimethylformamide (DMF), and spin coated onto the substrate. The substrate was then transferred to a hotplate where it was heated in atmosphere to 100°C for 30 min. After the substrates were cooled to room temperature, chlorobenzene solution containing the corresponding HTM and additives was applied to form the HTM film by leaving the solution to penetrate into the electrode for 10 s and then followed by spin-coating for 30 s with 3000 rpm. Afterwards, the cells were left in air overnight in the dark (humidity below

10%), then a 200 nm thick Ag back contact was deposited onto the organic semiconductor by thermal evaporation in a vacuum chamber with a base pressure of about $10^{-6}$ bar, to complete the device fabrication.

*Device Characterization*

Current-Voltage characteristics were recorded by applying an external potential bias to the cell while recording the generated photocurrent with a Keithley model 2400 digital source meter. The light source was a 300 W collimated xenon lamp (Newport) calibrated with the light intensity to 100 mW·cm$^{-2}$ at AM 1.5 G solar light condition by a certified silicon solar cell (Fraunhofer ISE). IPCE spectra were recorded on a computer-controlled setup comprised of a xenon lamp (Spectral Products ASB-XE-175), a monochromator (Spectral Products CM110) and a Keithley multimeter (Model 2700). The setup was calibrated with a certified silicon solar cell (Fraunhofer ISE) prior to measurements. The prepared ssDSC samples were masked during the measurement with an aperture area of 0.126 cm$^2$ (diameter 4 mm) exposed under illumination.

*Results*

The reorganization energy represents the relaxation of the molecule when one electron is withdrawn or donated, and the small reorganization energy implies fast transfer rate for electrons or holes to a certain extent. As indicated in Table 1 below, the molecule X51 has the calculated smallest reorganization energy that implies relative faster hole transport properties than the other two HTMs. These properties might be due to the larger conjugation length of X51 compared with SpiroOMeTAD and X19 from the structural point of view.

Cyclic Voltammetry (CV) (Figure 6) and Differential Pulse Voltammetry (DPV) (Figure 8b) for each of the HTMs were measured to determine the ground-state oxidation potential (Eox). Corresponding data are collected in Table 1 below. The Eox values were measured to be 0.61 V and 0.64 V vs. NHE in DCM solution, respectively. In consideration of the oxidation potential value (0.88Vvs NHE) of the LEG4 dye, all hole conductors have an overpotential between 270 m V and 240 m V which should be able to regenerate dye effectively. The optical absorption and fluorescence spectra (Figure 8a) in DCM were measured at a concentration of 10·5 M. All photophysical data of HTMs are listed in Table 1. X19 and X51 exhibit strong absorption peak at 310 nm and weak in intensity at 370 nm, while the absorption of Spiro-OMeTAD shows weak in intensity at 306 nm and strong absorption peak at 386 nm. The weak absorption at visible light region indicates that all of these HTMs will not contend the sunlight with the photosensitizer. In addition, the photoluminescence spectra show that X-HTMs have a homologous peak around 460 nm, which are slightly red shift compared with Spiro-OMeTAD. From the intersection of emission and absorption spectra we can obtain the $E_{0-0}$ transition and estimate the optical band gap (Table 1).

**Table 1.** Summary of optical, electrochemical, photoelectrical properties and reorganization energy of the HTMs used in this study.

| HTMs | $\lambda_{abs}$ [nm] | | $\lambda_{em}$ [nm] | $E_{ox}$ a) [V vs NHE] | $E_{o-o}$ b) [eV] | $E_R$ c) (meV) | Hole Mobility d) ($cm^2 \cdot V^{-1} \cdot s^{-1}$) | Conductivity e) ($S \cdot cm^{-1}$) |
|---|---|---|---|---|---|---|---|---|
| **X19** | 310(max) | 371 | 457 | 0.61 | 2.95 | 395 | $1.19\times10^{-4}$ | $2.88\times10^{-5}$ |
| **X51** | 307(max) | 365 | 469 | 0.64 | 2.93 | 378 | $1.51\times10^{-4}$ | $1.05\times10^{-4}$ |

a) 0.1 M of tetrabutylammoniun hexafluorophosphate (n-$Bu_4NPF_6$) in DCM as electrolyte; Ag/0.01 M $AgNO_3$ electrode (acetonitrile as solvent) as the reference electrode; a glassy carbon disk (diameter 3 mm) as the working electrode; a platinum wire as the counter electrode. Scan rate: 50mV/s. All redox potentials were calibrated vs. normal hydrogen electrode (NHE) by the addition of ferrocene. The conversion $E_{(Fc/Fc+)}$ = 630 mV vs NHE was used. b) Calculated from the intersection of the normalized absorption and emission spectra. c) $E_R$: reorganization energy,calculated using the four-point method based on the adiabatic potential energy surface d) Pure HTM without doping. e) X19 and X51 doped with 30 mM LiTFSI, Spiro-OMeTAD doped with 20 mM LiTFSI.

The HTM-X51 based devices exhibited high power conversion efficiencies (PCEs) of 6.0% and 9.8% in dye sensitized and perovskite sensitized solar cells, respectively. These results are comparable to the PCEs of 5.5% and 10.2% obtained by using the well-studied HTM Spiro-OMeTAD under standard AM 1.5 solar light of 100 mW·cm$^{-2}$ intensity. It was thus concluded that the carbazole-based HTM X51 can rival with the state-of-the-art HTM Spiro-OMeTAD both in ssDSCs and PSCs.

Fitting the J-V curves (Figure 6) for each material to this expression gives the mobility data listed in Table 2. The hole mobility values of X51 is slightly higher than that of X19, and both of these carbazole-based HTMs showed almost three times higher than that of Spiro-OMeTAD. These results are in good agreement with the computation that

the molecule X51 (Example 3) has the calculated smallest reorganization energy that implies relative fast hole transport properties.

We note that the conductivity of X51 is slightly higher than that of Spiro-OMeTAD, but much higher than that of X19, which might be due to the better conjugated system for the former, leading to more efficient n-n stacking of HTMs films. In this case, the hole mobility and conductivity values of X51 are higher than that of X19, so that the hole transfer of HTM-X51 could contribute to better photovoltaic parameters than these of X19, as well as Spiro-OMeTAD-based devices.

The measured curves and values Li-TFSI-doping HTMs are depicted in Table 2. We note that the conductivity of X51 is slightly higher than that of Spiro-OMeTAD, but much higher than that of X19, which might be due to the better conjugated system for the former, leading to more efficient $\pi$-$\pi$ stacking of HTMs films. In this case, the hole mobility and conductivity values of X51 are higher than that of X19, so that the hole transfer of HTM-X51 could contribute to better photovoltaic parameters than these of X19, as well as Spiro-OMeTAD-based devices.

The photovoltaic properties of these HTMs were investigated by fabricating ssDSCs using the high molar extinction coefficient organic dye LEG4. In order to compare the properties, the device with Spiro-OMeTAD as HTM has been used as reference. It has been widely demonstrated that lithium bis(trifluoromethanesulfonyl)imide (Li-TFSI) is essential in ssDSCs for achieving low series resistances and facilitating photocurrent generation. We firstly optimized the amount of Li-TFSI that added into the HTMs solution. The final optimal Li+ concentration for X19 and X51 based ssDSCs were 30 mM, J-V curves and photovoltaic parameters of different concentration of Li-TFSI doping see Figure 6 and Table 2. The optimal concentration of Li-TFSI with Spiro-OMeTAD was 20 mM. The J-V curve parameters of the best devices with different HTMs are shown in Table 2. The X51 -based device yielded the highest efficiency of up to 6.0% among these HTMs with short-circuit photocurrent density (Jsc) of 9.27 $mAcm^{-2}$ open-circuit photovoltage ($V_{oc}$) of 0.92 V and fill factor (FF) of 0.70. Under the optimal condition, the X19-based device gave lower efficiency of 4.5%, with *Jsc* of 9.62 $mA{\cdot}cm^{-2}$, Voe of 0.75 V and FF of 0.62. The standard HTM Spiro-OMeTAD based device reached a reference efficiency of 5.5% with *Jsc* of 9.22 $mAcm^{-2}$, *Voc* of 0.90 V and FF of 0.66. It was noted that the photocurrent density of all the devices can reach the same level after optimizing the concentration of Li-TFSI. For LEG4 dye, all of these HTMs exhibit the similar IPCE of 65% at the maximum absorption wavelength of 475 nm (Figure 9a). However, the open-circuit voltage of the X19 based device was 170 mV and 150 mV lower than that of the Spiro-OMeTAD and X51-based devices, respectively. One reason owing to the HOMO levels of X51 and Spiro-OMeTAD are more positive than X19; another factor might due to the smaller molecular size of the former that induce fast electron recombination in the device.

Furthermore, devices with this HTMs were further fabricated using perovskite as light-harvesting materials under the same preparation conditions without any device optimization, while the concentration of Li-TFSI and t-BP were the same as in case of ssDSC devices. The configuration of this typical solid-state perovskite solar cell is compact $TiO_2$/nc$TiO_2$/$CH_3NH_3PbI3_{-x}Cl_x$/HTM/ Ag. A 350 nm thick nc-$TiO_2$ layer was deposited by spin-coating a diluted paste and $CH_3NH_3PbI_{3-x}Cl_x$ was employed as the light harvester in virtue of the large electron-hole diffusion lengths in the mixed halide perovskiter. The J-V curves obtained from the best performing solar cells are showed in Figure 6, corresponding photovoltaic parameters are summarized in Table 2. The device prepared with Spiro-MeOTAD exhibited the highest efficiency of 10.2%, with *Jsc* of 16.82 $mA{\cdot}cm^{-2}$, *Voc* of 0.83 V and FF of 0.73, while X51-based device gave a comparable efficiency of 9.8%, with *Jsc of* 16.79$mA\text{-}cm^{-2}$, *Voc* of 0.88 V and FF of 0.66. The device prepared with X19 yielded Jsc of 17.14 $mA{\cdot}cm^{-2}$, *Voc of 0.76* V and FF of 0.58, and PCE of 7.6%, which is the lowest compared with the other HTMs. In addition, a comparative trial with higher concentration of LiTFSI (30 mM) doping in Spiro-OMeTAD solution was conducted, whereas the efficiency was similar with 20 mM Li-TFSI doping. Meanwhile, we noticed that the *Jsc* values of the best devices agreed well with the results obtained from IPCE measurements (Figure 9b). However, the Voc and fill factors differed significantly, X51-based device exhibited the highest Vor among all of the HTMs, which agreed well with the HOMO levels of X51 is higher than that of the other HTMs. Moreover, the fill factor values of X51 and Spiro-OMeTAD-based devices both in ssDSCs and perovskite solar cells were much higher than that of X19, which might be due to the higher conductivity of the formers because of higher conductivity of the HTM can decrease the hole transfer resistance in cell.

**Table** 2: Photovoltaic parameters determined from J-V measurements of ssDSCs and perovskite solar cells doping with different concentration of Li-TFSI based on carbazol based HTMs. Measured under simulated AM1.5G solar irradiance (100 mW·cm$^{-2}$).

| Photosensitizers | HTMs | Li-TFSI [mM] | $V_{OC}$ [V] | $J_{SC}$ [mA·cm$^{-2}$] | FF | η [%] |
|---|---|---|---|---|---|---|
| **LEG4** a) | **X19**b) | 20 | 0.83 | 8.56 | 0.53 | 3.8 |
| | | 30 | 0.75 | 9.62 | 0.62 | 4.5 |
| | | 40 | 0.70 | 9.91 | 0.59 | 4.0 |
| | **X51**c) | 20 | 0.96 | 7.80 | 0.68 | 5.1 |
| | | 30 | 0.92 | 9.27 | 0.70 | 6.0 |
| | | 40 | 0.87 | 10.09 | 0.63 | 5.5 |
| | **Spiro-OMeTAD**d) | 10 | 0.94 | 8.12 | 0.63 | 4.8 |
| | | 20 | 0.90 | 9.22 | 0.66 | 5.5 |
| | | 30 | 0.86 | 10.12 | 0.60 | 5.2 |
| **Perovskite** e) | **Spiro-OMeTAD**f) | 20 | 0.83 | 16.82 | 0.73 | 10.2 |
| | | 30 | 0.81 | 19.37 | 0.64 | 10.0 |

a)2.0 μm $TiO_2$ film; b)200 mM HTM doped with 200 mM t-BP; c)90 mM HTM doped with 200 mM t-BP; d)150 mM HTM doped with 200 mM t-BP; e)350 nm $TiO_2$ film; e)70 mM HTM doped with 200 mM t-BP.

Example 3: Computation of electrochemical properties of the carbazol based HTMs

In the simulation, optimization and single point energy calculations are performed using the cam-B3LYP (A. D. Becke, The Journal of Chemical Physics 1993, 98, 1372) and the 6-31G** basis set for all atoms, without any symmetry constraints. All reported calculations were carried out by means of Gaussian 09 (M. J. Frisch *et al,* Gaussian Inc. Wallingford CT 2009).

The reorganization energy $\lambda$, is determined by four energies, (the Nelson four-point method) (C. Lee, R. Waterland, K. Sohlberg, Journal of Chemical Theory and Computation 2011, 7, 2556; S. F. Nelsen, S. C. Blackstock, Y. Kim, Journal of the American Chemical Society 1987, 109, 677):

$$\lambda = E_+^* - E_+ + E^* - E$$

Where the $E_+^*$ is the energy of the neutral molecule in the cation symmetry, and the $E^*$ is the energy of the cationic molecule in the neutral symmetry; the $E_+$ and $E$ are the optimized energies of the cationic and neutral molecules.

Non-adiabatic Marcus theory is used for calculate the charge transfer rate (R. A. Marcus, N. Sutin, Biochimica Et Biophysica Acta 1985, 811, 265), R:

$$R = \frac{2\pi}{\hbar} \frac{|J|^2}{\sqrt{4\pi\lambda k_B T}} e^{-\frac{(\Delta G_0 + \lambda)^2}{4k_B T}}$$

Where the λ is the reorganization energy, the J describes the electronic coupling, and $\Delta G_0$ is the free energy between the equilibrium states of the products and reactants. According to Marcus theory, HTM-X51with the lowest reorganization energy, has the much higher hole transfer rates than X19 and Spiro-OMeTAD.

*Results*

DFT calculations of the highest occupied molecular orbital (HOMO) and the lowest unoccupied molecular orbital (LUMO) of the HTMs X19 and X51 are shown in Fig. 7. The values of the calculated HOMO and LUMO of these HTMs have been summarized in Table 3 below, which make it clear that the energy of HOMO levels of all HTMs show little difference.

Table 3: Calculated electrochemical properties of the HTMs. Energy levels are given vs. vacuum.

| Energy (eV) | X19 | X51 | Spiro-OMeTAD |
|---|---|---|---|
| LUMO | 0.50 | 0.08 | 0.48 |
| HOMO | -5.43 | -5.49 | -5.46 |
| $E_{gap}$ | 5.93 | 5.57 | 5.94 |

## Claims

1. A hole-conducting material comprising a compound of the general formula $B_1$-$A_1$-$B_2$ wherein $B_1$ represents a structure of formula I

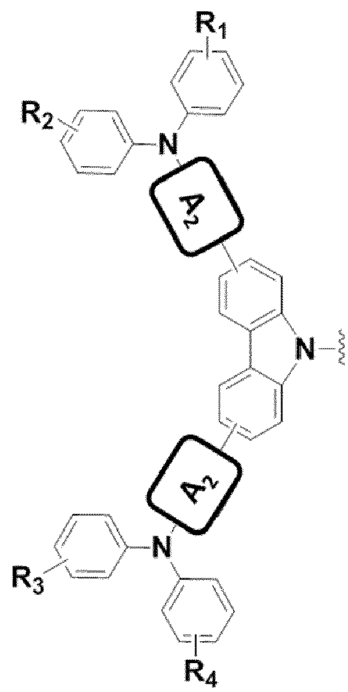

(I),

wherein $A_2$ represents a structure independently selected from the group consisting of

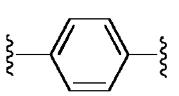
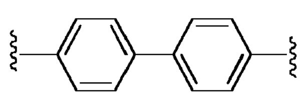
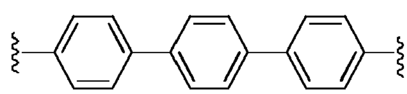

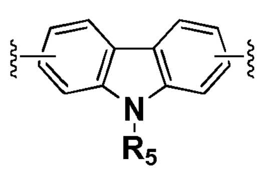
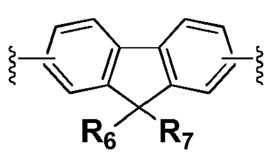
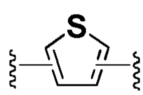

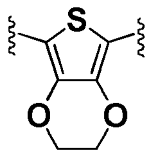
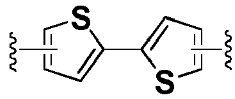
and
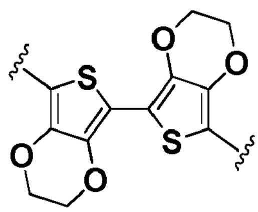

or wherein $A_2$ is independently absent, $A_1$ represents a structure independently selected from the group consisting of

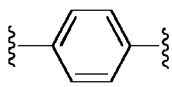
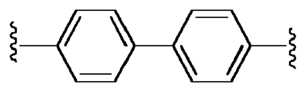
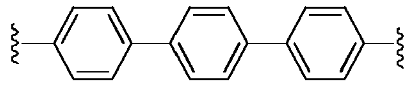

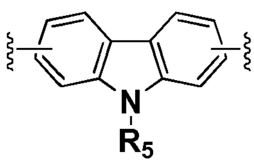
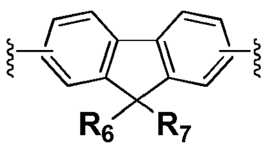
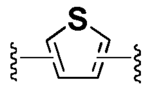

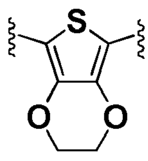
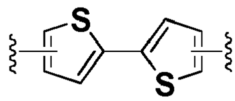
and
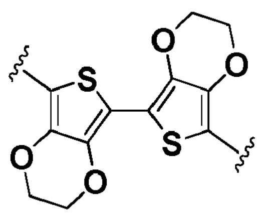

and $B_2$ represents a structure of formula I, or $A_1$ is

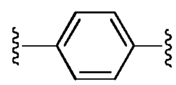

and $B_2$ is $R_8$, and each of $R_1$, $R_2$, $R_3$, $R_4$, $R_5$, $R_6$, $R_7$, and $R_8$ independently represents alkoxy, aryloxy, alkyl, aryl or hydrogen.

**2.** The hole-conducting material according to any one of the preceding claims, wherein $A_2$ is absent.

**3.** The hole-conducting material according to any one of the preceding claims wherein $A_1$ is

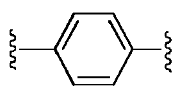
.

**4.** The hole-conducting material according to claims 1 or 2, wherein $A_1$ is

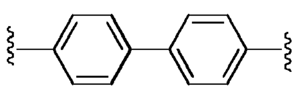
.

**5.** The hole-conducting material according to any one of the preceding claims, wherein at least one of $R_1$, $R_2$, $R_3$, and

$R_4$ is methoxy, preferably at least two of $R_1$, $R_2$, $R_3$, and $R_4$ are methoxy, more preferably at least three of $R_1$, $R_2$, $R_3$, and $R_4$ are methoxy, and most preferably wherein each of $R_1$, $R_2$, $R_3$, and $R_4$ is methoxy.

**6.** The hole-conducting material according to any one of the preceding claims, wherein $B_2$ is absent.

**7.** The hole-conducting material according to any one of the preceding claims, wherein $B_2$ represents a structure of formula I.

**8.** The hole-conducting material according to any one of the preceding claims, wherein said compound of general formula $B_1$-$A_1$-$B_2$ is a compound of formula II:

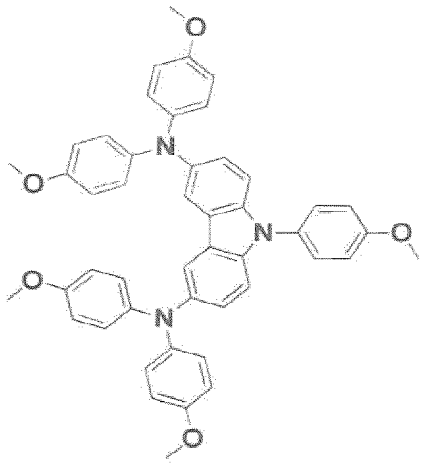

(II).

**9.** The hole-conducting material according to any one of the preceding claims, wherein said compound of general formula $B_1$-$A_1$-$B_2$ is a compound of formula III:

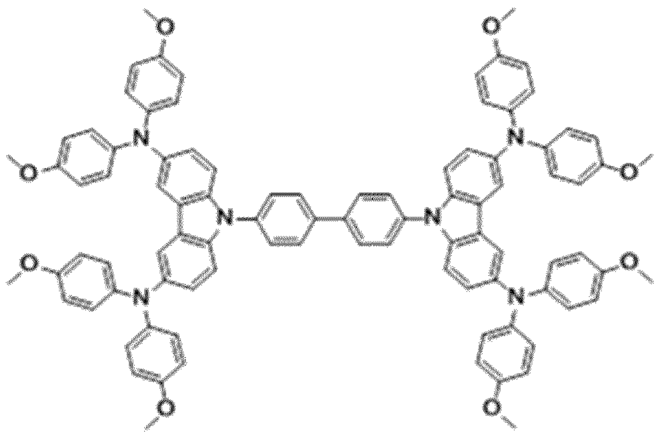

(III).

**10.** The hole-conducting material according to any one of the preceding claims, wherein said compound of general formula $B_1$-$A_1$-$B_2$ is in solid state.

**11.** A solar cell device comprising a hole-conducting material according to any one of claims 1 to 10.

**12.** The solar cell device according to claim 11, wherein said device is selected from a dye-sensitized solar cell and a hybrid solar cell, preferably a solid state dye-sensitized solar cell.

**13.** A process for preparing a hole-conducting material, said process comprising the steps of:

a) providing carbazole;
b) subjecting said carbazole of step a) to arylation;
c) subjecting said carbazole of step b) to a Pd catalyzed aryl amination, and optionally,
d) repeating steps a) - c), and
e) reacting the compound of step c) with the compound of step d).

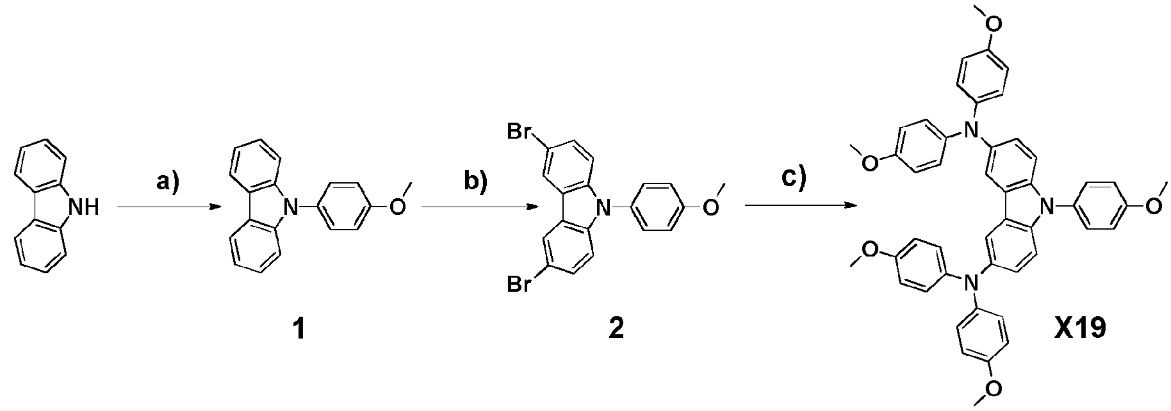


1 2 X19

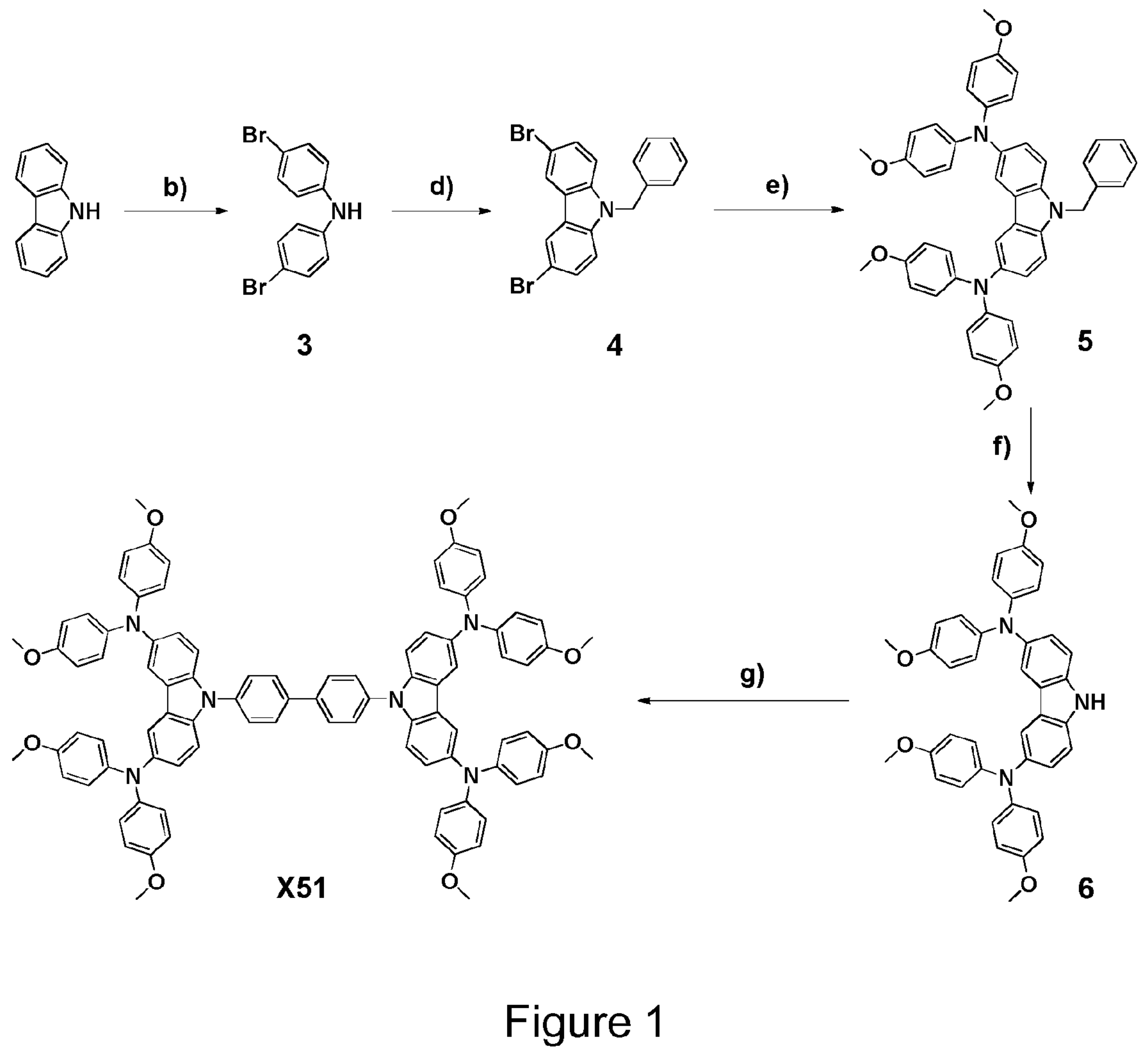


3 4 5

X51 6

Figure 1

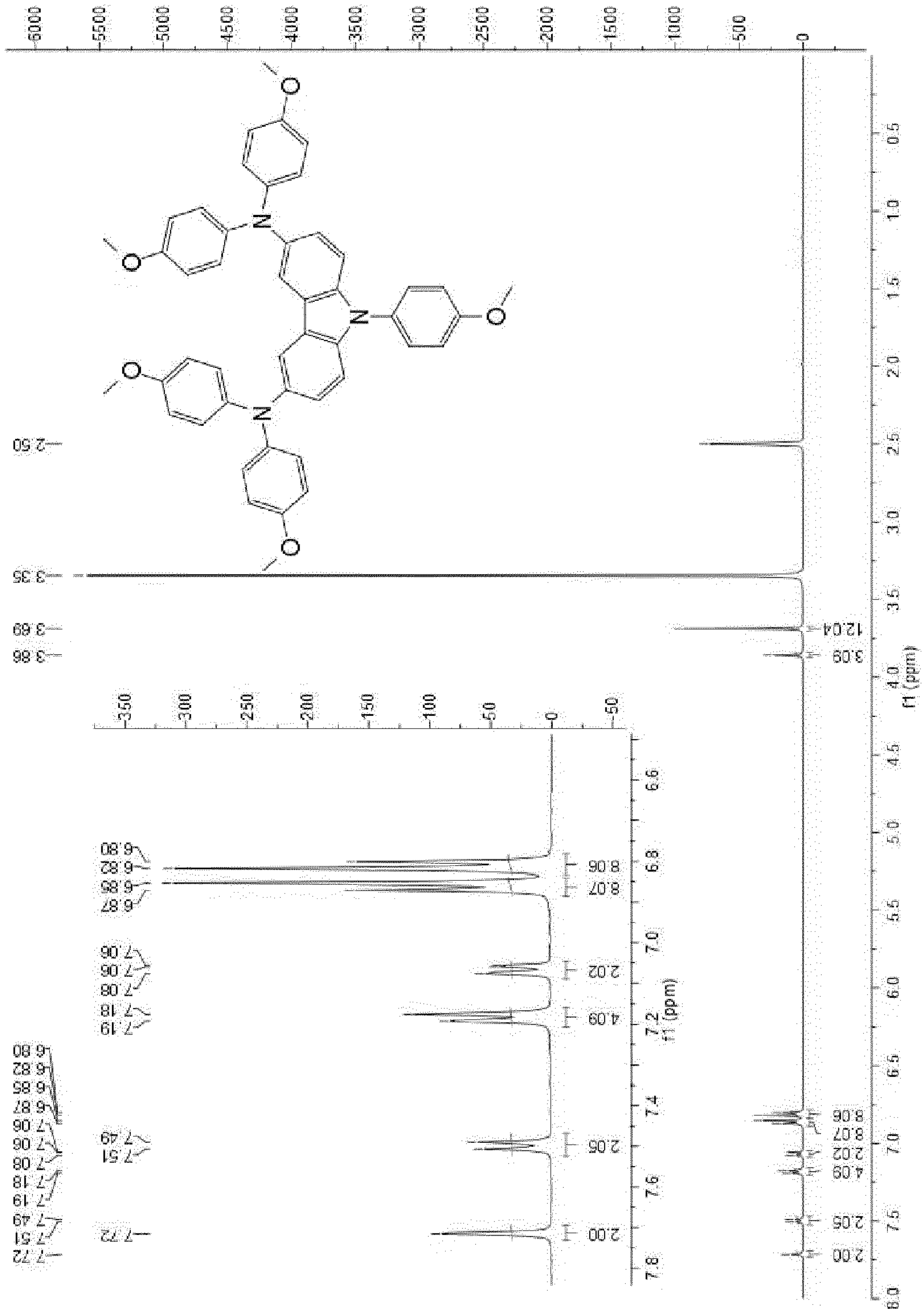
2.50
3.35
3.69
3.86
6.80
6.82
6.85
6.87
7.06
7.06
7.08
7.18
7.19
7.49
7.51
7.72
12.04
3.09
8.06
8.07
2.02
4.09
2.05
2.00
f1 (ppm)

Figure 2a

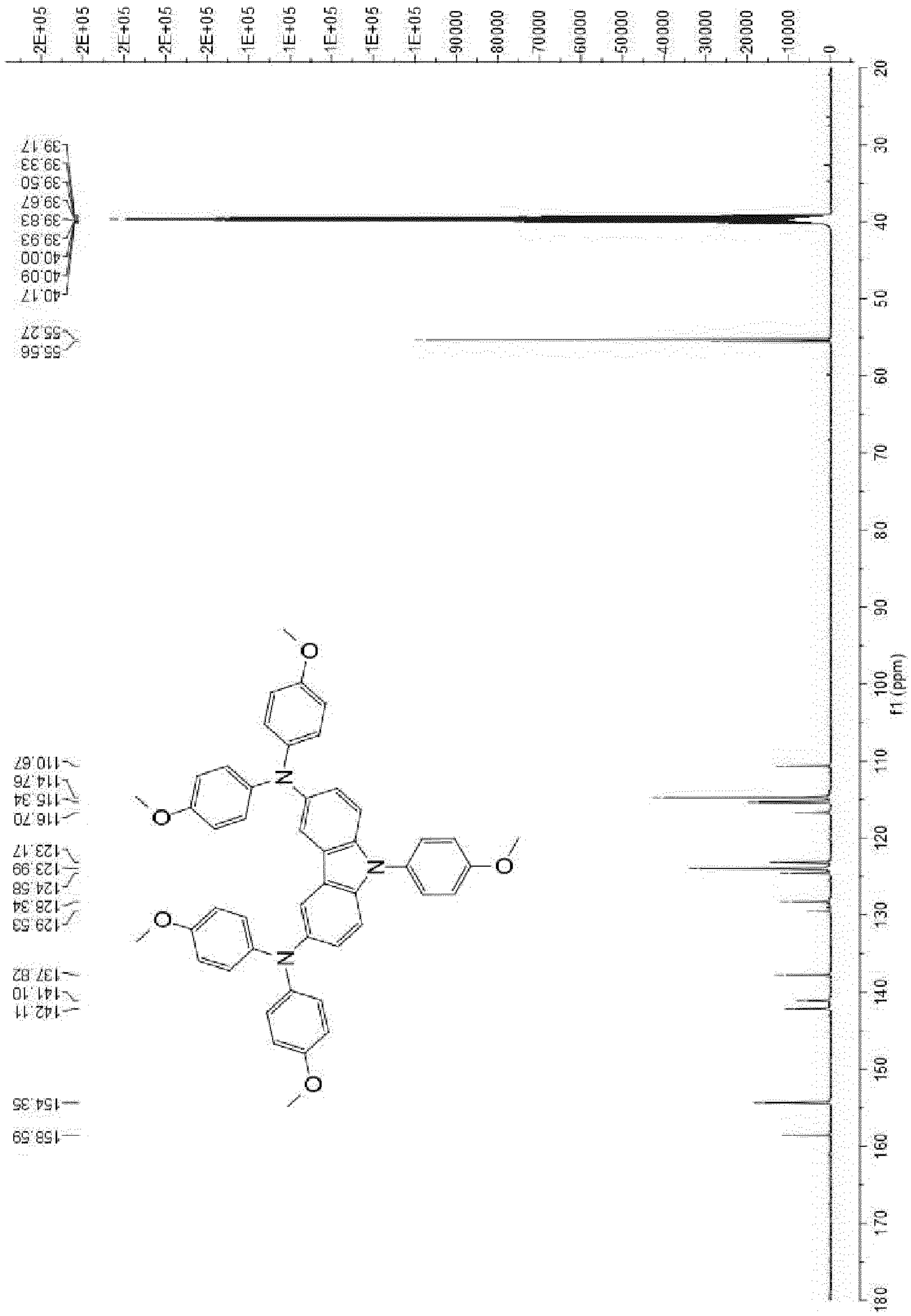
39.17
39.33
39.50
39.67
39.83
39.93
40.00
40.09
40.17
55.27
55.56
110.67
114.76
115.34
116.70
123.17
123.99
124.58
128.34
129.53
137.82
141.10
142.11
154.35
158.59
f1 (ppm)

Figure 2b

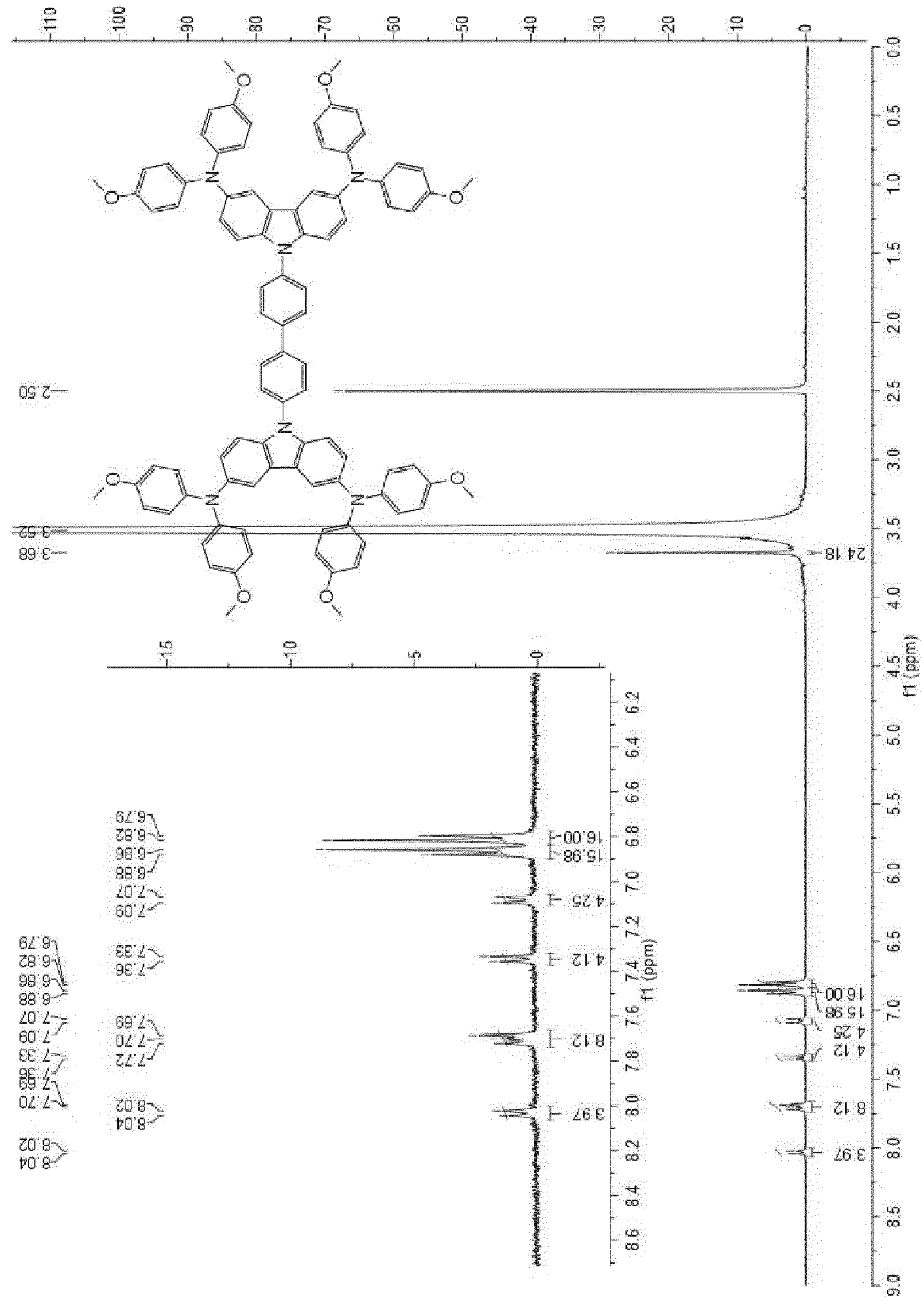
2.50
3.52
3.68
24.18
6.79
6.82
6.86
6.88
7.07
7.09
7.33
7.36
7.69
7.70
7.72
8.02
8.04
16.00
15.98
4.25
4.12
8.12
3.97
f1 (ppm)

Figure 3a

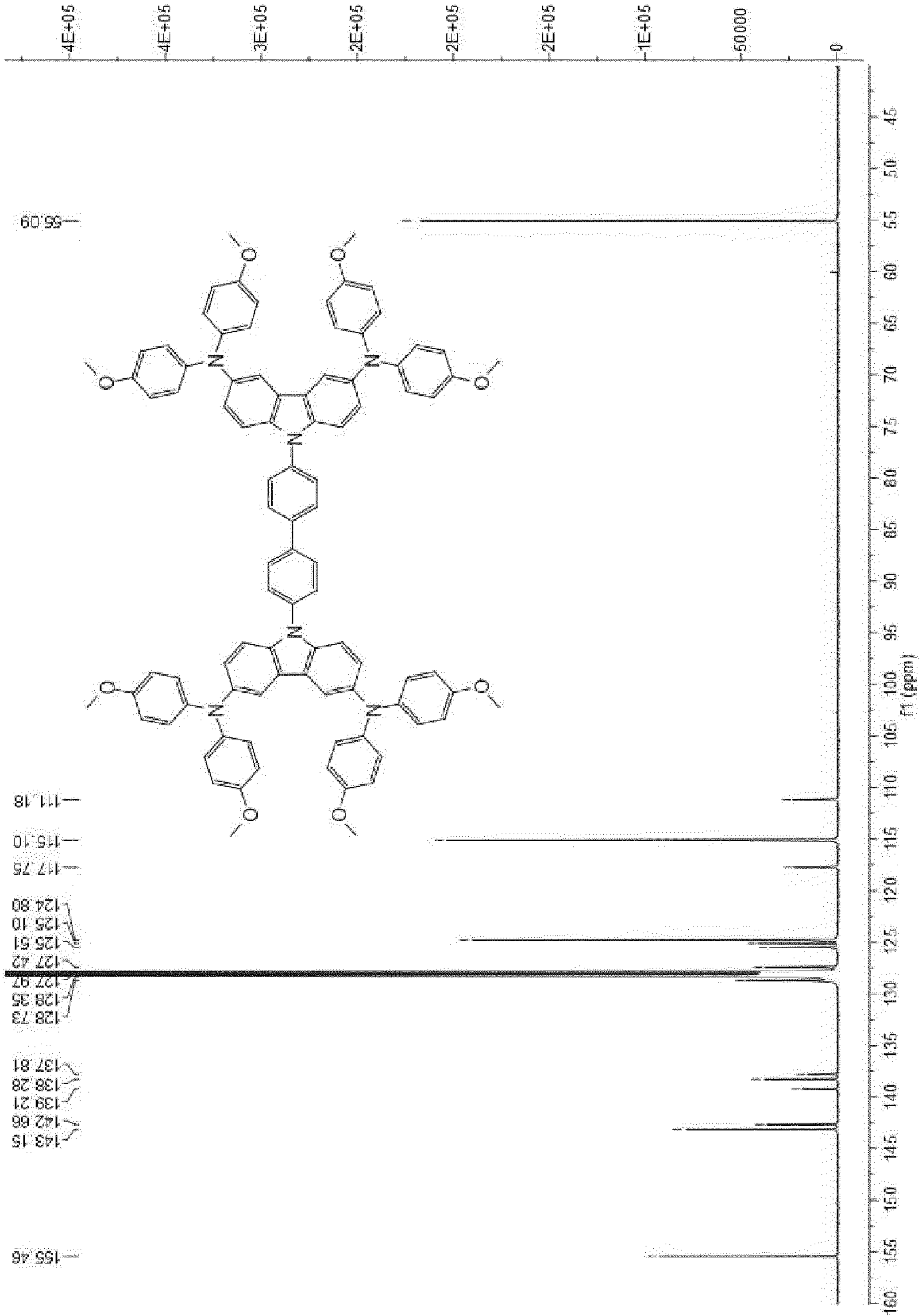
55.09
111.18
115.10
117.75
124.80
125.10
125.61
127.42
127.97
128.35
128.73
137.81
138.28
139.21
142.66
143.15
155.46
f1 (ppm)

Figure 3b

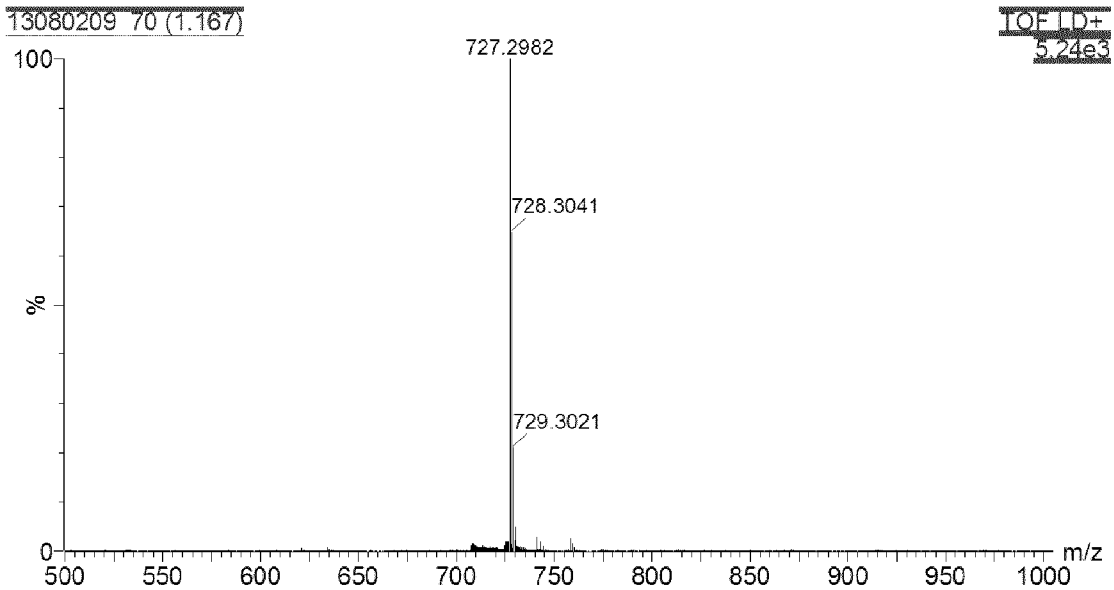
13080209 70 (1.167)
TOF LD+
5.24e3
727.2982
728.3041
729.3021
100
%
0
500
550
600
650
700
750
800
850
900
950
1000
m/z

a

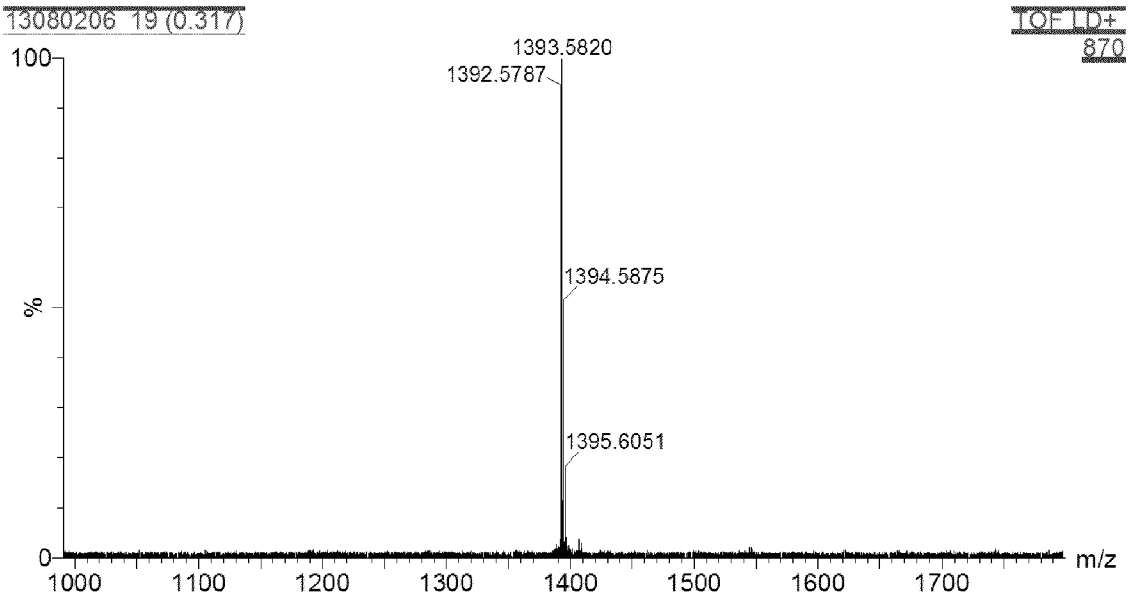
13080206 19 (0.317)
TOF LD+
870
1393.5820
1392.5787
1394.5875
1395.6051
100
%
0
1000
1100
1200
1300
1400
1500
1600
1700
m/z

b

Figure 4

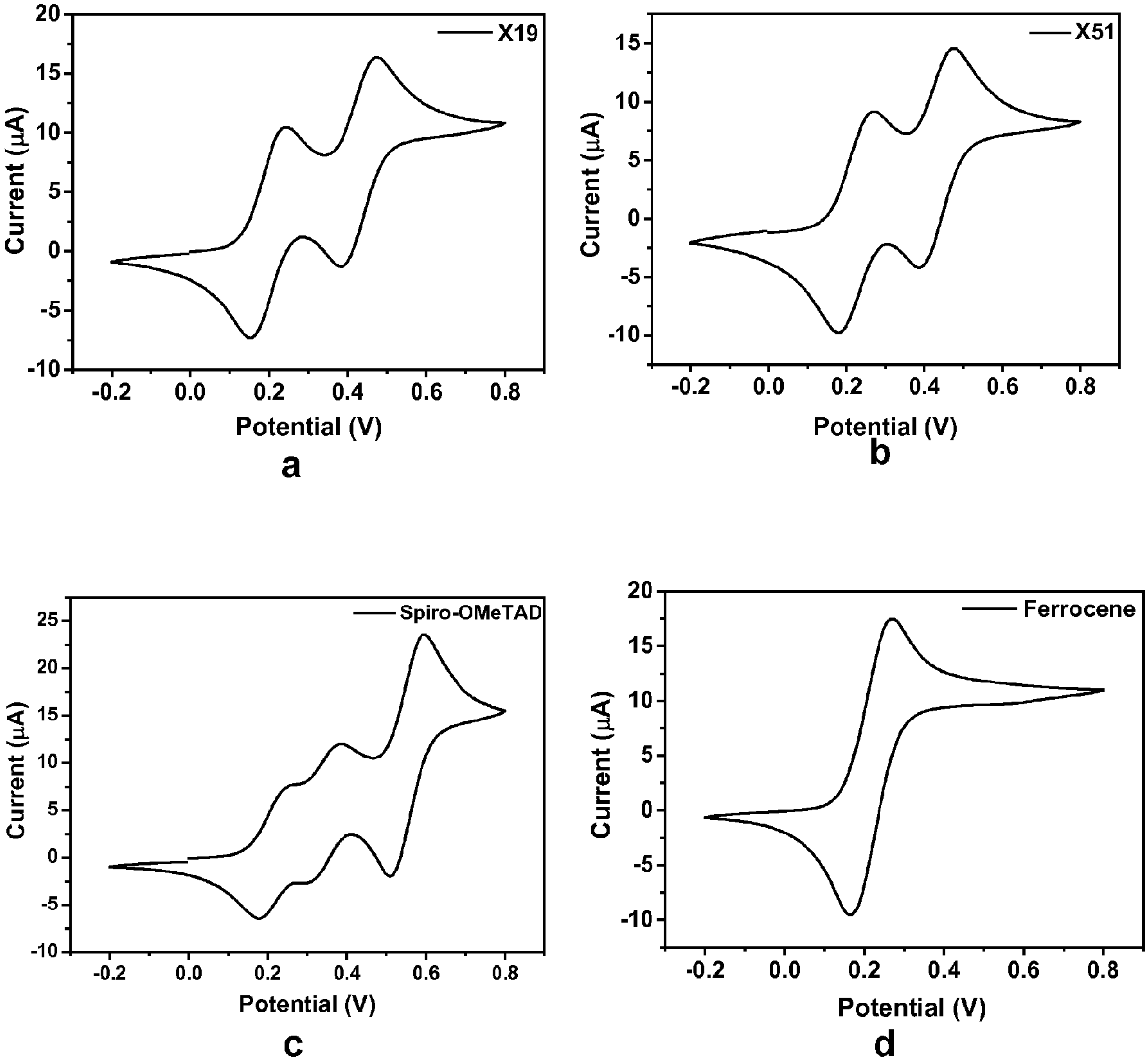
X19
Current (μA)
Potential (V)
a
X51
Current (μA)
Potential (V)
b
Spiro-OMeTAD
Current (μA)
Potential (V)
c
Ferrocene
Current (μA)
Potential (V)
d

Figure 5

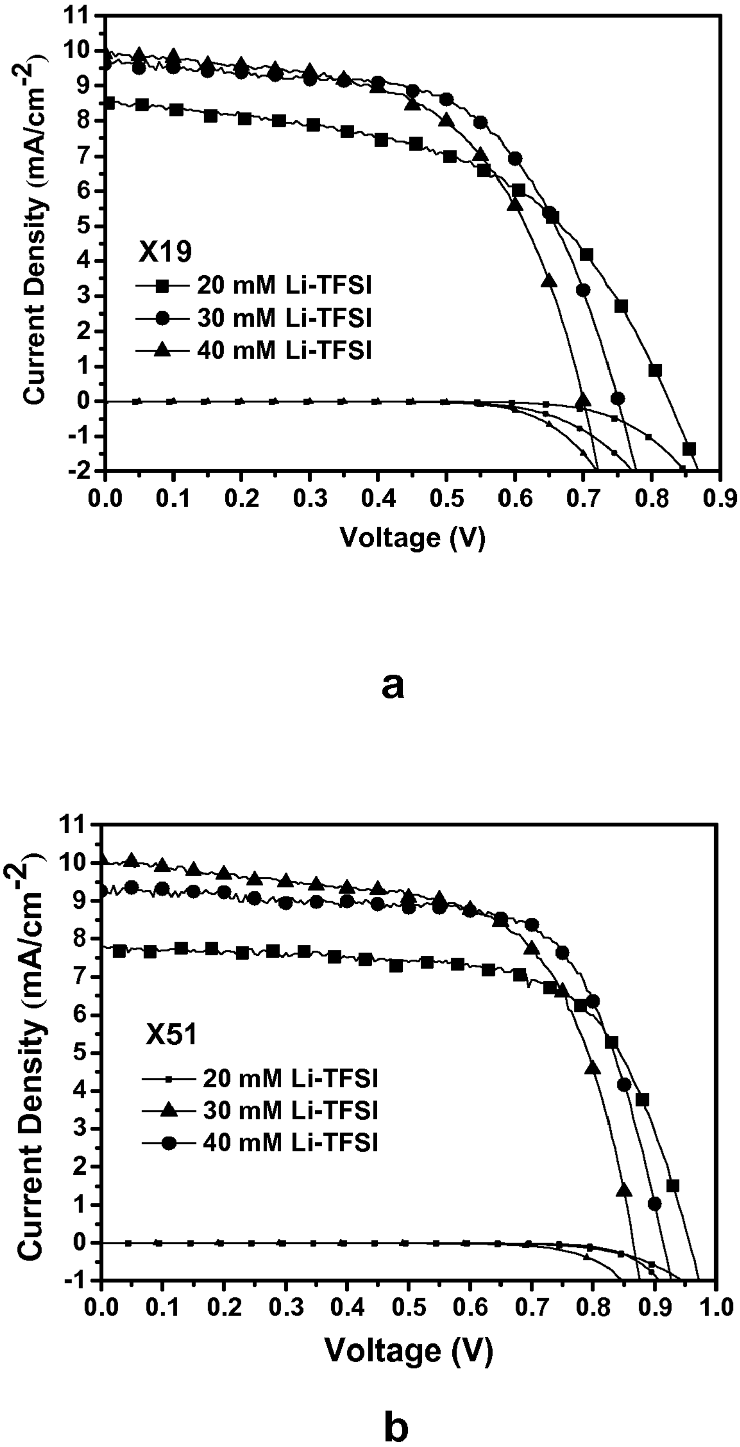
X19
20 mM Li-TFSI
30 mM Li-TFSI
40 mM Li-TFSI
Current Density (mA/cm$^{-2}$)
Voltage (V)
a
X51
20 mM Li-TFSI
30 mM Li-TFSI
40 mM Li-TFSI
Current Density (mA/cm$^{-2}$)
Voltage (V)
b

Figure 6

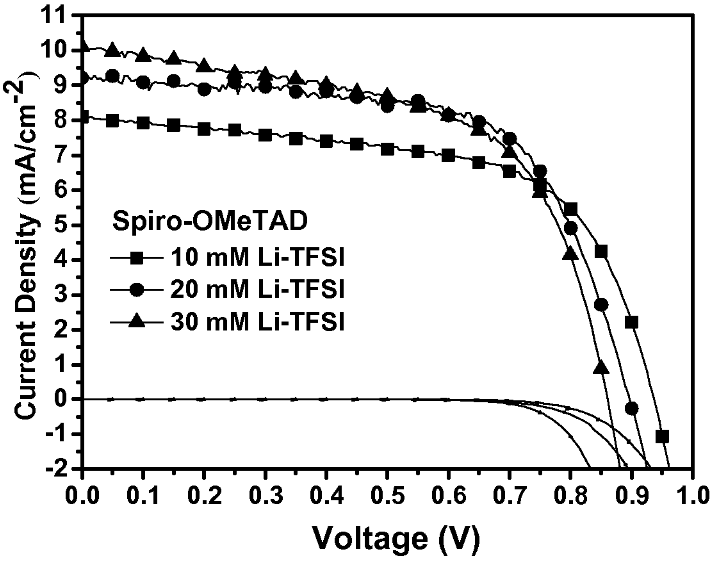

Current Density (mA/cm-2)
Voltage (V)
Spiro-OMeTAD
10 mM Li-TFSI
20 mM Li-TFSI
30 mM Li-TFSI


c

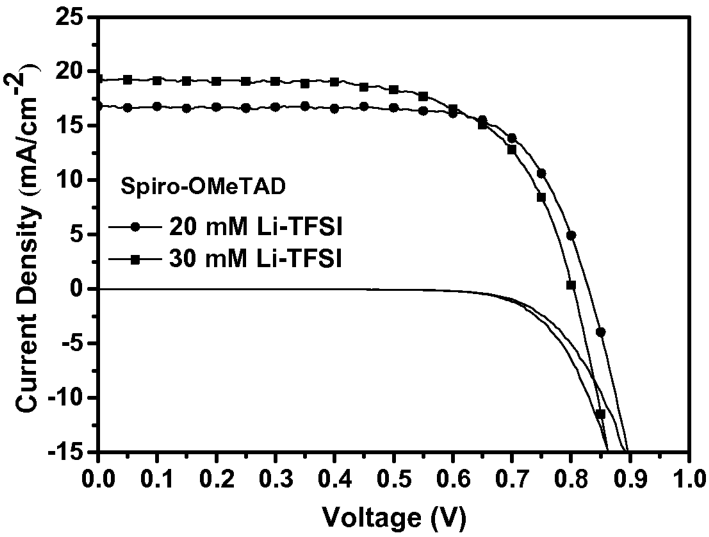

Current Density (mA/cm-2)
Voltage (V)
Spiro-OMeTAD
20 mM Li-TFSI
30 mM Li-TFSI


d

Figure 6

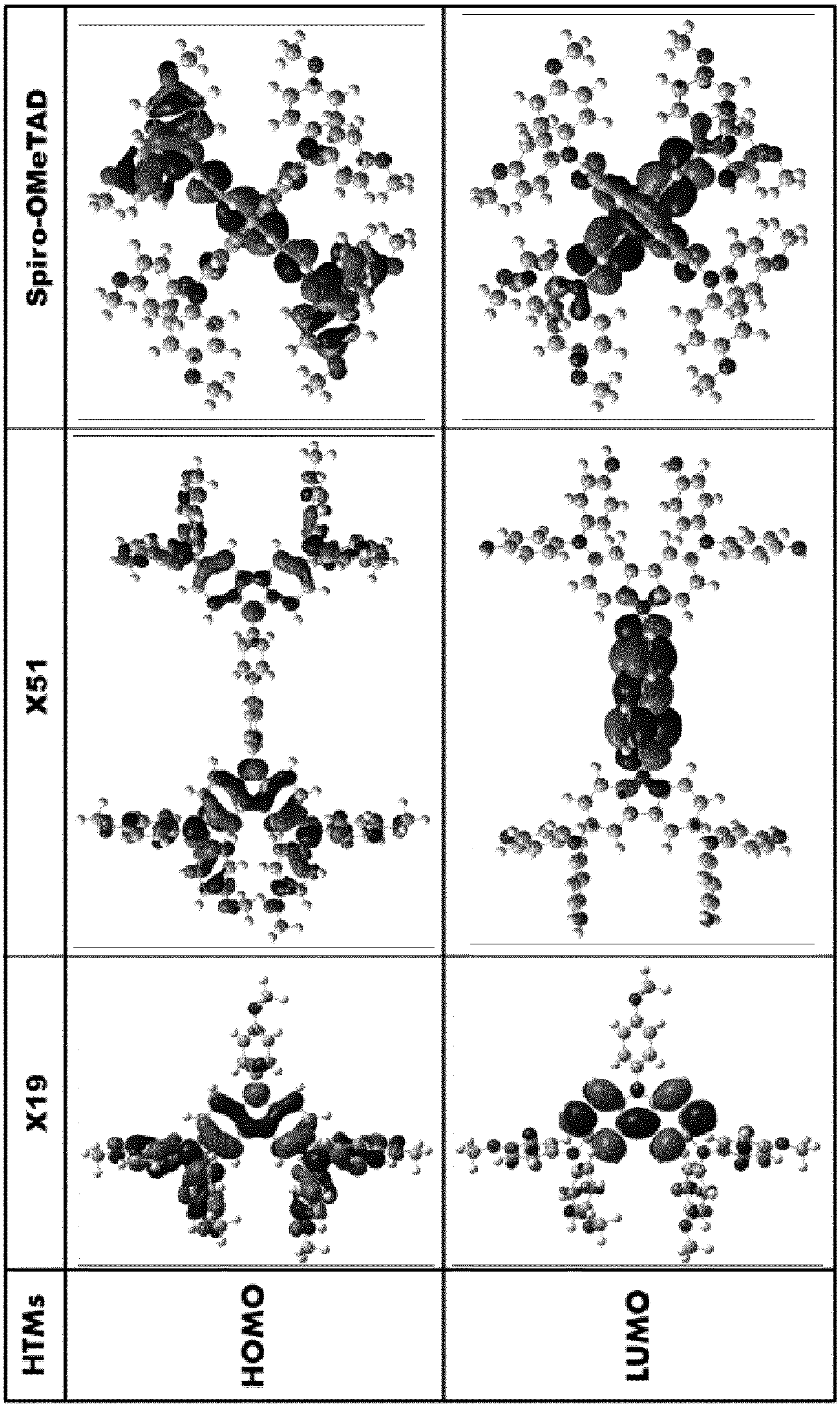


Figure 7

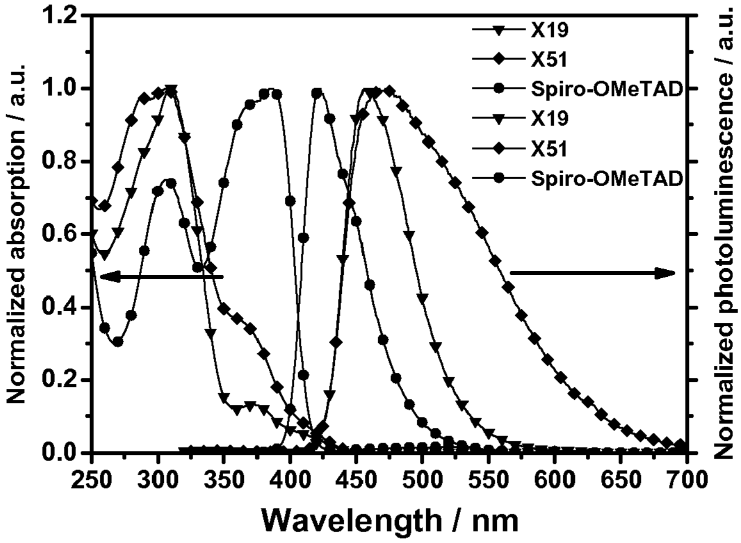
1.2
1.0
0.8
0.6
0.4
0.2
0.0
Normalized absorption / a.u.
Normalized photoluminescence / a.u.
X19
X51
Spiro-OMeTAD
X19
X51
Spiro-OMeTAD
250 300 350 400 450 500 550 600 650 700
Wavelength / nm

a

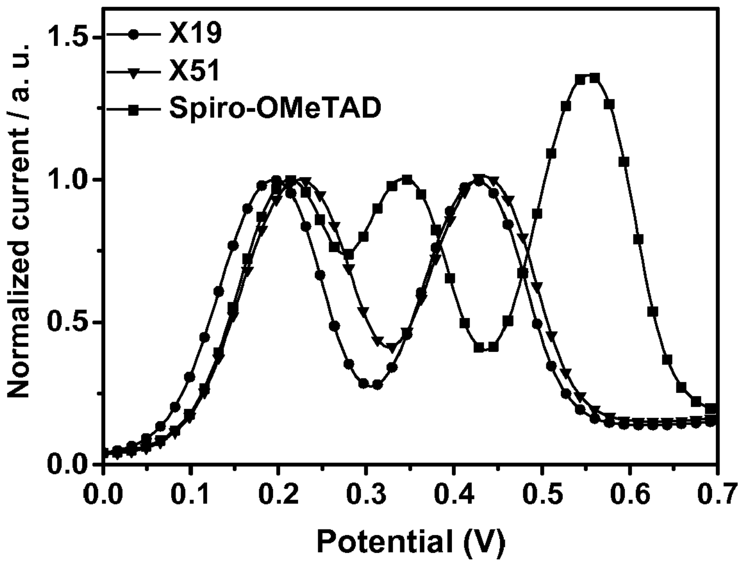
1.5
1.0
0.5
0.0
Normalized current / a. u.
X19
X51
Spiro-OMeTAD
0.0 0.1 0.2 0.3 0.4 0.5 0.6 0.7
Potential (V)

b

Figure 8

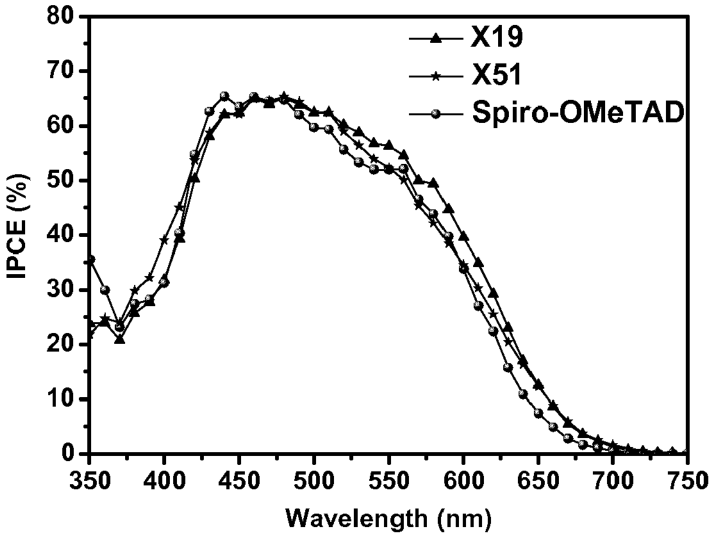
X19
X51
Spiro-OMeTAD
IPCE (%)
Wavelength (nm)
0
10
20
30
40
50
60
70
80
350
400
450
500
550
600
650
700
750

a

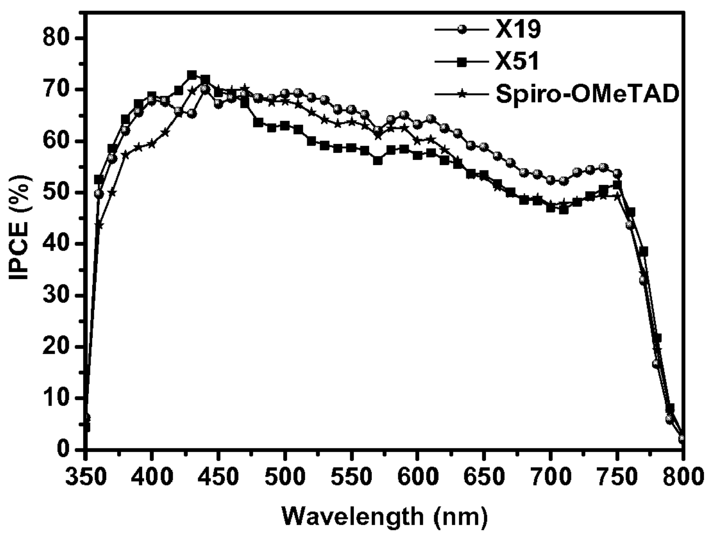
X19
X51
Spiro-OMeTAD
IPCE (%)
Wavelength (nm)
0
10
20
30
40
50
60
70
80
350
400
450
500
550
600
650
700
750
800

b

Figure 9

Europäisches Patentamt
European Patent Office
Office européen des brevets

# EUROPEAN SEARCH REPORT

Application Number
EP 14 17 6715

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | KUNDU P ET AL: "HIGH-TG CARBAZOLE DERIVATIVES AS BLUE-EMITTING HOLE-TRANSPORTING MATERIALS FOR ELECTROLUMINESCENT DEVICES", ADVANCED FUNCTIONAL MATERIALS, WILEY - V C H VERLAG GMBH & CO. KGAA, DE, vol. 13, no. 6, 1 June 2003 (2003-06-01), pages 445-452, XP001162507, ISSN: 1616-301X, DOI: 10.1002/ADFM.200304308 * page 445 - page 455; figures; compounds 9,11-14 * ----- | 1-4,6, 10-13 | INV. C09K11/06 H05B33/10 |
| X | JIANPING LU ET AL: "Synthesis and Properties of Multi-Triarylamine-Substituted Carbazole-Based Dendrimers with an Oligothiophene Core for Potential Applications in Organic Solar Cells and Light-Emitting Diodes", CHEMISTRY OF MATERIALS, AMERICAN CHEMICAL SOCIETY, US, vol. 18, 1 January 2006 (2006-01-01), pages 6194-6203, XP007917161, ISSN: 0897-4756, DOI: 10.1021/CM0621110 [retrieved on 2006-12-19] * page 6194 - page 6203; figures * ----- | 1,6,7, 10-12 | TECHNICAL FIELDS SEARCHED (IPC) C09K H05B H01L |
| X | LI ZHONG HUI ET AL: "Synthesis and Functional Properties of End-Dendronized Oligo(9,9-diphenyl)fluorenes", ORGANIC LETTERS, AMERICAN CHEMICAL SOCIETY, US, vol. 8, no. 7, 1 January 2006 (2006-01-01), pages 1499-1502, XP002459251, ISSN: 1523-7060, DOI: 10.1021/OL0604062 * page 1499 - page 1500; figures * ----- -/-- | 1,7,13 | |

1

The present search report has been drawn up for all claims

| Place of search | Date of completion of the search | Examiner |
|---|---|---|
| Munich | 22 August 2014 | Doslik, Natasa |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

Europäisches Patentamt
European Patent Office
Office européen des brevets

# EUROPEAN SEARCH REPORT

Application Number
EP 14 17 6715

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | TOMAS LEIJTENS ET AL: "Hole Transport Materials with Low Glass Transition Temperatures and High Solubility for Application in Solid-State Dye-Sensitized Solar Cells", ACS NANO, vol. 6, no. 2, 28 February 2012 (2012-02-28), pages 1455-1462, XP55136015, ISSN: 1936-0851, DOI: 10.1021/nn204296b<br>* page 1455 - page 1460; figures *<br>----- | 5,8,9 | |

TECHNICAL FIELDS SEARCHED (IPC)

1

The present search report has been drawn up for all claims

| Place of search | Date of completion of the search | Examiner |
|---|---|---|
| Munich | 22 August 2014 | Doslik, Natasa |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description


- **A. VELLA et al.** *Science,* 2011, vol. 334, 629
- **S. MATHEW et al.** *Nat Chem,* 2014, vol. 6, 242
- **J. BURSCHKA et al.** *JACS,* 2011, vol. 133, 18042
- **H.-S. KIM et al.** *Nature,* 2013, vol. 499, 316
- **A. W. SCHMIDT et al.** *Journal of Power Sources,* 2013, vol. 233, 86
- **T. LEIJTENS et al.** *ACS Nano,* 2012, vol. 6, 1455
- **M. M. LEE et al.** *Science,* 2012, vol. 338, 643
- **A. D. BECKE.** *The Journal of Chemical Physics,* 1993, vol. 98, 1372
- **C. LEE ; R. WATERLAND ; K. SOHLBERG.** *Journal of Chemical Theory and Computation,* 2011, vol. 7, 2556
- **S. F. NELSEN ; S. C. BLACKSTOCK ; Y. KIM.** *Journal of the American Chemical Society,* 1987, vol. 109, 677
- **R. A. MARCUS ; N. SUTIN.** *Biochimica Et Biophysica Acta,* 1985, vol. 811, 265